# EUROPÄISCHE PATENTSCHRIFT

(11) **EP 1 927 063 B1**
(45) Veröffentlichungstag und Bekanntmachung des Hinweises auf die Patenterteilung: **30.03.2016**
(21) Anmeldenummer: 06805765.2
(22) Anmeldetag: 19.09.2006
(51) Int. Cl.: G06F 17/50

(54) **PROGRAMMIERUNG UND LAYOUTDESIGN VON HARDWARE**
HARDWARE PROGRAMMING AND LAYOUT DESIGN
PROGRAMMATION ET SCHEMA DE CONFIGURATION DE MATERIEL

(30) Priorität: 19.09.2005 DE 102005044728
(43) Veröffentlichungstag der Anmeldung: 04.06.2008
(73) Patentinhaber: Silicon Software GmbH, 68163 Mannheim (DE)
(72) Erfinder: LAY, Ralf, 68165 Mannheim (DE); NOFFZ, Klaus-Henning, 68259 Mannheim (DE)
(74) Vertreter: Dennemeyer & Associates S.A.
(86) Internationale Anmeldenummer: PCT/EP2006/009081
(87) Internationale Veröffentlichungsnummer: WO 2007/033812

(56) Entgegenhaltungen:
- EP-A2- 0 645 723
- WO-A-99/09498
- US-A- 6 145 073
- US-A1- 2002 080 174
- US-A1- 2002 178 285
- WONG C G ET AL: "An architecture for asynchronous FPGAs" FIELD-PROGRAMMABLE TECHNOLOGY (FPT), 2003. PROCEEDINGS. 2003 IEEE INTERNATIONAL CONFERENCE ON 15-17 DEC. 2003, PISCATAWAY, NJ, USA,IEEE, 15. Dezember 2003 (2003-12-15), Seiten 170-177, XP010688333 ISBN: 0-7803-8320-6

## Beschreibung

### Gebiet der Erfindung

Die Erfindung betrifft ein Verfahren zum Programmieren von Hardware, beispielsweise FPGA's (Field Programmable Gate Array), oder zur Generierung von Layouts, beispielsweise für logische Schaltungen bzw. integrierte Schaltkreise, etwa ASIC's (Application Specific Integrated Circuit) oder Mikroprozessoren, für die Verarbeitung von Daten, beispielsweise auf dem Gebiet der industriellen digitalen Bildverarbeitung. Ferner betrifft sie logische Schaltungen, die gemäß den im Verfahren angegebenen Prinzipien aufgebaut sind.

### Stand der Technik

Als Werkzeuge für die Programmierung von Hardware, beispielsweise von FPGA's, dienen Hardwarebeschreibungssprachen, wie u.a. VHDL (Very High Speed Integrated Circuit Hardware Description Language), die es ermöglichen, komplizierte digitale Systeme zu beschreiben.

Ein Problem bei den meisten Hardwarebeschreibungssprachen ist jedoch, dass Hardwaremodule formuliert werden, die in ihrer Schnittstelle, an die das Modul angeschlossen werden soll, feste, implizite Annahmen an den Daten- und Kontrollfluss (Protokoll und Daten) machen. Das bedeutet, dass zunächst keine Hardwaremodule direkt miteinander verbunden werden können, ohne die genaue Implementierung der Module zu kennen. Dies widerspricht modernen Ansätzen der Softwareentwicklung und behindert die Wiederverwertbarkeit von Code.

Es ist bekannt, dass Hardwaremodule nur dann miteinander verbunden werden können, wenn ihre genaue Implementierung bekannt ist. Das Fehlen von kompatiblen Schnittstellen zwischen Modulen bedeutet gleichzeitig eine fehlende Portierbarkeit von Code von einer Hardware auf eine andere. Das Auftreten eines eventuellen Datenstaus oder von Datenverlusten ist nicht auszuschließen bzw. nur mit erheblichem Aufwand zu verhindern.

Diese Situation erfordert gegenwärtig noch eine aufwändige Programmierung der Hardwaremodule, beispielsweise von FPGA's bzw. ASIC's.

Die Druckschrift US 2002/0080174 A1 zeigt ein Verfahren, welches das Programmieren von Hardware für die Verarbeitung von Nutzdaten erleichtern soll, wobei auch die Verwendung einer grafischen Oberfläche und die Umsetzung grafischer Symbole in programmierte Hardware vorgesehen sind. Vorgesehen ist auch, dass der Datenfluss zwischen Modulen durch parallel laufende sog. "*enable*"-Signale teilweise gesteuert wird. Der Datenfluss kann sich hierdurch allerdings nicht vollständig selbst regulieren (ggf. Scheduler o.ä. erforderlich) und kann zudem nur sehr schwer optimiert werden, da unklar ist, ob und wann stromabwärts gelegene Module das jeweils nächste Datenelement verarbeiten können. Ein Pipelining der Daten kann hiermit kaum erreicht werden.

Die Druckschrift US 2002/0178285 A1 befasst sich mit der Modellierung von Datenflüssen. Hierzu werden verschiedene Protokolle und auch die Umwandlung dieser Protokolle ineinander beschrieben. Zudem wird dort offenbart, zur vollständigen Kontrolle eines Datenflusses neben einem "*valid*"-Signal, welches die Gültigkeit der Daten bestätigt, ein "*ready*"-Signal zu verwenden, welches dem Datenfluss entgegenläuft und die Bereitschaft eines stromabwärts gelegenen Moduls anzeigt, Daten zu empfangen.

In der Druckschrift US 6,145,073, die sich mit der Vereinfachung des Designs von großen Systemen auf einem Chip befasst, ist ein Protokoll offenbart, bei dem das in Bezug auf den Datenstrom stromaufwärts liegende Modul ein "*ready*"-Signal und das stromabwärts liegende Modul ein "*request*"-Signal sendet.

### Aufgabe

Aufgabe der Erfindung ist es, das Programmieren von Hardware zu verbessern.

### Lösung

Diese Aufgabe wird durch die Erfindungen mit den Merkmalen der unabhängigen Ansprüche gelöst. Vorteilhafte Weiterbildungen der Erfindungen sind in den Unteransprüchen gekennzeichnet. Der Wortlaut sämtlicher Ansprüche wird hiermit durch Bezugnahme zum Inhalt dieser Beschreibung gemacht. Die Erfindung umfasst auch alle sinnvollen und insbesondere alle erwähnten Kombinationen von unabhängigen und/oder abhängigen-Ansprüchen.

Die Aufgabe wird u.a. durch ein Verfahren gelöst. Im Folgenden werden einzelne Verfahrensschritte näher beschrieben. Die Schritte müssen nicht notwendigerweise in der angegebenen Reihenfolge durchgeführt werden, und das zu schildernde Verfahren kann auch weitere, nicht genannte Schritte aufweisen.

Zunächst wird für das Verfahren zum Programmieren von Hardware für die Verarbeitung von Nutzdaten eine Mehrzahl von Modulen zur Verfügung gestellt, wobei jedes Modul mindestens eine Funktion zum Verarbeiten der Nutzdaten ausführen kann. Die Funktion wird durch den Anwender bestimmt und hängt davon ab, welche Prozesse durch die zu programmierende Hardware realisiert werden sollen.

Als Modul wird eine abgegrenzte Einheit bezeichnet, die in Hardware realisiert oder in einer höheren Repräsentationssprache dargestellt ist, welche eine bestimmte Funktion ausführen kann und über Schnittstellen mit anderen Modulen kommunizieren kann. Module können dabei fest vorgegeben sein oder flexibel parametrisierbar sein.

Die Module werden dazu nach vorgegebenen Eigenschaften in eine Mehrzahl von Modultypen klassifiziert. Die Eigenschaften für die Klassifizierung in unterschiedliche Modultypen werden dahingehend ausgewählt, dass sie konkrete Aussagen darüber beinhalten, wie Module zur Realisierung einer Topologie (siehe unten) miteinander verschaltet werden können bzw. welche Verschaltungen (siehe unten) zulässig sind.

Als nächster Schritt werden Schnittstellen zum Verschalten der Module vorgegeben. Dabei gilt das Prinzip, dass eine Daten ausgebende Schnittstelle am Ausgang eines ersten Moduls mit einer Daten empfangenden Schnittestelle am Eingang des nächsten Moduls übereinstimmen muss, d. h. die diesbezüglichen Parameter der Module müssen übereinstimmen.

Die Module werden daher so parametrisiert, wie es für die benötigte Funktion erforderlich ist und dass Aus- bzw. Eingänge aufeinander so abgestimmt sind, dass ein Zusammenwirken der Module gewährleistet ist.

Im Detail gibt es für jedes Modul vier Implementierungen:
- die parametrisierbare Beschreibung des Moduls, das später synthetisiert, d. h. auf die Hardware übersetzt wird;
- eine Simulationsbeschreibung des Moduls; -
- eine Beschreibung der Schnittstelle (Links, Parameter, Format, Bereichsgrenzen etc.);
- eine Beschreibung der Zugriffsschnittstelle in Hardware, die angibt, welche Parameter bzw. Register ein Anwender während der Laufzeit im Modul verändern kann und wie dies möglich ist.

In Abhängigkeit von den Modultypen werden konkrete Verschaltungsregeln derart definiert, dass die Steuerung des Datenflusses zwischen den verschalteten Modulen über Inhibit-Signale erfolgt. Dabei können die Inhibit-Signale von einem Modultyp erzeugt werden. Durch ein aktives Inhibit-Signal wird der Nutzdatenfluss gestoppt.

Ein weiterer Verfahrensschritt besteht darin, dass eine Verschaltung von Modulen (eine Topologie), die einer für die Verarbeitung der Nutzdaten geeigneten Abfolge von Funktionen entspricht, vorgegeben wird.

Danach wird aus der Topologie die Hardware-Programmierung erzeugt.

Die Modelle und Regelwerke, die dem Verfahren zugrunde liegen, enthalten Mechanismen, die es ermöglichen, die Hardwaremodule so zu formulieren, dass sie aneinander anschließbar sind. Dabei kann eine Programmierung von Hardware (beispielsweise FPGA's oder ASIC's) durch den Anwender ohne genaue Detailkenntnisse des Hardwareentwurfs realisiert werden.

An der Schnittstelle eines Moduls existiert eine Datenstruktur (Link), die aus verschiedenen Signalen besteht. Es sind das die Nutzdatensignale (DATA), und/oder Kontrollsignale (CTRL), das Taktsignal (CLK) sowie evtl. ein Inhibit-Signal (INH).

Über die Links wird der Datenaustausch zwischen den Modulen durchgeführt. Im Prinzip stellen sie eine gerichtete Datenverbindung her, die zusätzlich über Kontrollmechanismen zur Datenflusskontrolle verfügen. Der Typ des Datenformats wird strukturiert festgelegt und muss zwischen Sender und Empfänger übereinstimmen.

Dabei transportieren die Nutzdatensignale die Nutzdaten. Sie können beliebig aufgebaut und strukturiert sein. Insbesondere sind dabei auch verschachtelte Strukturen zulässig.

Die Kontrollsignale übermitteln Zusatzinformationen zeitgleich zu den Nutzdatensignalen. Aus den Kontrollsignalen muss sich die Gültigkeit der Nutzdaten erkennen lassen. Dazu kann ein bestimmtes einzelnes Signal oder auch eine Kombination mehrerer Signale genutzt werden. Ein Beispiel für ein CTRL-Signal ist u. a. ein Valid für eine Datumsvariable.

Für den Empfang von Daten sind Input-Links und für die Ausgabe von Daten sind Output-Links definiert.

Dabei ermöglichen die Schnittstellen die Verbindung eines Ausgangs eines ersten Moduls mit einem Eingang eines zweiten Moduls. Für jeden Ausgang eines Moduls wird eine Datenstruktur vom Typ Output-Link vorgesehen, während für jeden Eingang eines Moduls eine Datenstruktur vom Typ Input-Link vorgesehen wird.

Bei einem Input-Link sind alle Daten- und Kontrollsignale sowie das Taktsignal Eingangssignale, das Inhibit-Signal jedoch ein Ausgangssignal. Bei einem Output-Link sind alle Daten- und Kontrollsignale sowie das Taktsignal Ausgänge, das Inhibit-Signal ist jedoch Eingang. Alle Änderungen der Signale erfolgen synchron zum Takt. Input- und Output-Links können nur miteinander verbunden werden, wenn sie denselben Takt verwenden.

Die korrekte Bearbeitung eingehender Daten wird in einem Modul durch mindestens eine Funktions-Logik realisiert. Die Funktions-Logik ist eine in Hardware realisierte Funktion zur Verarbeitung der Daten.

Ausgangsseitig wird ein Modul durch eine Output-Latency charakterisiert. Die Output-Latency ist eine Moduleigenschaft und wird vom Programmierer des Moduls ermittelt und zur Verfügung gestellt. Es gibt Module mit konstanten Output-Latencys aber auch Module, bei der die Output-Latencys von den Einstellungen der Parameter abhängt. Die Output-Latency eines Moduls gibt an, welche maximale Anzahl von gültigen Datenworten der Output-Link noch senden kann, wenn keine neuen Daten mehr eingehen, d. h. wie viele Daten ein Modul noch senden kann, wenn man es anhält. Diese Anzahl muss von der nachfolgenden Verarbeitungskette immer aufgenommen werden können, wenn kein Datenverlust eintreten soll. Ist dies durch die verwendeten Module nicht gewährleistet, so werden automatisch die entsprechenden Steuerelemente in Form von Verzögerungs- oder Puffer- oder Fifo-Elementen eingefügt, um diesen Zustand zu gewährleisten.

Die Datenströme zwischen den Modulen werden durch Quellmodule erzeugt, durch Verarbeitungsmodule bearbeitet und verändert und durch Senkenmodule angenommen. Die Verbindung dieser Module über die Links erzeugt ein sich selbst regelndes Netzwerk von Datenflüssen. Die Prinzipien dieses Regelkreislaufes und die möglichen Topologien des Netzwerkes sind durch das erfindungsgemäße Regelwerk festgelegt. Das Regelwerk ist so ausgelegt, dass nicht nur die lokalen Verbindungen untereinander in Datenfluss und Datenformat angepasst werden, sondern dass auch garantiert wird, dass der Gesamtdatenfluss durch das Design (Topologie) verlustfrei transportiert wird.

Für das erfindungsgemäße Verfahren werden, wie oben beschrieben, verschiedene Modultypen mit jeweils konkreten Eigenschaften definiert. Zur Unterscheidung werden dabei die Module als Module der Typen "O" (O-Modul), "P" (P-Modul) und "M" (M-Modul) bezeichnet. Die Typ-Bezeichnung kennzeichnet jeweils sowohl die Eigenschaften eines Moduls als auch dessen Verschaltungsregeln. Die Wahl der Namen ist willkürlich.

### O-Modul

O-Module sind die einfachsten Module. Ein O-Modul kann die Werte von Nutzdaten ändern, aber keine Nutzdaten löschen.

Der Kontrolldatenfluss wird durch das O-Modul nicht beeinflusst.

Das in einem Link enthaltene Inhibit-Signal hat keinen Einfluss auf das O-Modul.

Die Daten erfahren beim Durchlaufen des O-Moduls eine Verzögerung (Latency)mit einer genau definierten Anzahl von Takten, die in der Regel der Anzahl der Registerstufen entspricht, die die Nutzdaten auf dem Datenpfad vom Input-Link zum Output-Link durchlaufen. Ein O-Modul ist daher ein deterministisches Modul mit genau N Takten.

Besitzt ein O-Modul mehreren Input-Links, so müssen die Nutzdaten an diesen gleichphasig anliegen. Das Inhibit-Signal wird bei einem O-Modul mit mehreren Input-Links identisch auf alle Input-Links geleitet.

Auf Grund seiner Eigenschaften kann ein O-Modul keinen Datenstau und auch keinen Datenverlust verursachen. Die Nutzdatenmenge ändert sich bei einem O-Modul nicht, die Datenwerte können sich jedoch durchaus ändern, z. B. durch Addition. Es werden keine Daten gelöscht oder erzeugt. Ebenfalls ändert sich nicht die Anzahl der Valids. Es müssen bei einem O-Modul nicht alle Registerstufen tatsächlich gültige Daten enthalten.

### P-Modul

Ein weiterer für das beschriebene Verfahren verwendeter Modultyp ist das P-Modul. Es hat einen komplexeren Charakter, als ein O-Modul.

Ein P-Modul kann die Werte von Nutzdaten ändern und Nutzdaten löschen. Ein P-Modul hat insbesondere die Möglichkeit, weniger Datenworte zu liefern, als es empfängt.

Ebenso kann das P-Modul den Kontrolldatenfluss ändern und löschen. Auf Grund seiner Eigenschaften kann ein P-Modul den Kontrolldatenfluss beeinflussen, aber nur derart, dass die absolute Datenrate reduziert wird. Daraus resultiert, dass die Anzahl und die zeitliche Lage der Kontrollsignale einschließlich Data-Valid variabel sind. Mit anderen Worten: ein P-Modul kann den Valid Strom verändern, indem es die Anzahl der Valids reduzieren kann.

Ein Inhibit-Signal hat keinen Einfluss auf das P-Modul.

Die Daten erfahren beim Durchlaufen des P-Moduls eine genau definierte maximale Verzögerung (maximale Latency). Dabei kann die Verzögerung, die einzelne Nutzdaten erfahren, auch kleiner als die maximale Verzögerung sein. Ein P-Modul ist daher ebenfalls ein deterministisches Modul mit max. N Takten.

Bei einem P-Modul mit mehreren Input-Links müssen die Daten an diesen gleichphasig anliegen. Die Funktions-Logik wird dabei mit Kontrolldaten aus mindestens einem der Input-Links gespeist. Das Inhibit-Signal wird bei einem P-Modul mit mehreren Input-Links identisch auf alle Input-Links geleitet.

Nach einem Stoppen des Eingangsdatenflusses kann ein P-Modul maximal die Anzahl von Datenworten liefern, die durch die Output-Latency definiert ist.

Bei einem aktiven Inhibit-Signal können durch das Modul noch beliebig viele Datenworte aufgenommen werden. Ein Inhibit-Signal passiert ein P-Modul ohne Verzögerung. D. h., dass ein P-Modul ein Inhibit einfach nur weiter leitet. Es verändert den Inhibitstrom nicht. Diss ist auch nicht erforderlich, da ein P-Modul den Datenstrom immer nur reduzieren, aber nicht erhöhen kann. Eine aktive Steuerung des Inhibitsignals ist jeweils nur dann notwendig, wenn mehr Daten erzeugt werden können, als empfangen wurden, oder wenn eine unbestimmte Verzögerung eintreten kann, sodass ein Anhalten der Kette eingangsseitig notwendig sein kann, weil die Daten ausgangsseitig nicht mehr abgenommen werden.

Ein Beispiel für ein P-Modul ist u. a. die Umwandlung von 24 Bit RGB-Bilddaten in 32 Bit verschachtelte Bilddaten. Bei einem Vorgang dieser Art wird die Anzahl der Datenworte und damit der Kontrollsignale reduziert.

### M-Modul

Ein dritter für das beschriebene Verfahren verwendeter Modultyp ist das M-Modul. Dieses ist das komplexeste der vorgeschlagenen Module.

Das M-Modul kann die Werte von Nutzdaten ändern, Nutzdaten löschen und neue Nutzdaten erzeugen.

Den Kontrolldatenfluss kann das M-Modul ändern, löschen und erzeugen.

Weiterhin kann das M-Modul ein Inhibit-Signal erzeugen.

Die Daten erfahren beim Durchlaufen des M-Moduls eine unbestimmte Verzögerung. Ein M-Modul ist daher ein nicht deterministisches Modul.

Auf ihrer jeweiligen Eingangsseite besitzen M-Module einen Eingangspuffer mit einer bestimmten Puffergröße (Buffer-Size) zur Speicherung von Daten. Diese Buffer-Size des Input-Links eines Moduls bestimmt, welche maximale Anzahl von gültigen Datenworten der Link noch aufnehmen kann, nachdem das Inhibit-Signal aktiviert wurde.

Bei einem M-Modul mit mehreren Input-Links können eingehende Nutzdaten sowie Kontrolldaten aus unabhängigen Quellen (Input-Links) stammen.

Ein M-Modul kann auf Grund seiner Eigenschaften den Datenfluss explizit beeinflussen, wobei der Datenfluss auch vollständig angehalten werden kann. Der Datenfluss wird über Inhibit-Signale gesteuert. Bei einem aktivierten Inhibit-Signal kann maximal noch die durch die Output-Latency des M-Moduls bestimmte Anzahl Datenworte ausgegeben werden. Die Anzahl und die zeitliche Lage der Kontrollsignale einschließlich Data-Valid ist variabel. Ein M-Modul kann weniger oder mehr Datenworte liefern als es empfängt.

Wie oben beschrieben, erfolgen alle Änderungen von Signalen synchron zum Takt. Das bedeutet jedoch keine Einschränkung auf Systeme, die nur einen einzigen Takt haben. Wahrend O- und P-Module das gleiche Taktsignal an den Input- und Output-Links benötigen, können M-Module auf der Input- und Output-Seite unterschiedliche Takt-Signale (CLK-Signale) verarbeiten. Die Synchronisierung der Daten bezüglich der unterschiedlichen Input- und Output-Clocks wird im M-Modul vorgenommen. Somit können auch Hardwarebeschreibungen mit mehreren unterschiedlichen synchronen Taktsignalen erzeugt werden.

### Verschaltung

Die Verschaltung von Modulen der beschriebenen unterschiedlichen Modultypen erfolgt nach konkreten, für jeden Modultyp spezifischen Regeln.

Die Verschaltung des Ausganges eines O- oder P-Moduls mit dem Eingang eines nachfolgenden O- oder P-Moduls, d. h. eine Serienschaltung dieser Module, ist uneingeschränkt möglich. Die maximale Output-Latency der Gesamtanordnung ergibt sich aus der Summe der maximalen Output-Latencies der einzelnen Module. Die Gesamtanordnung kann nach aktivem Inhibit-Signal noch beliebig viele Daten aufnehmen.

Bei der Verschaltung des Ausgangs eines O- oder P-Moduls mit dem Eingang eines M-Moduls (Serienschaltung) muss die Buffer-Size des M-Moduls größer sein als die Output-Latency des O- oder P-Moduls. Andernfalls muss ein Puffer eingefügt werden, der die überzähligen Datenworte zwischenspeichern kann. Dies wird automatisch durchgeführt. Die Gesamtanordnung kann nach aktivem Inhibit-Signal nur noch so viele Daten aufnehmen, wie durch Buffer-Size und einen eventuell eingefügten Puffer spezifiziert ist. Die Output-Latency der Gesamtanordnung entspricht der Output-Latency des M-Moduls.

Die Verschaltung des Ausgangs eines M-Moduls mit dem Eingang eines O- oder P-Moduls (Serienschaltung) ist uneingeschränkt möglich. Die Gesamtanordnung kann nach aktivem Inhibit-Signal nur noch so viele Daten aufnehmen wie durch die Buffer-Size des M-Moduls spezifiziert ist. Bei der Bestimmung der maximale Output-Latency der Gesamtanordnung ist die Reihenfolge wichtig:
a) O/P-M: Das M-Modul entkoppelt die Logik des O-Moduls und reagiert auf ein Inhibit in der Topologie rechts von diesem zusammengesetzten Modul. Damit bestimmt in dieser Anordnung das M-Modul allein die OutputLatency der Verschaltung.
b) M-O/P: Hier addiert sich die OutputLatency des M-Moduls mit der maximalen OutputLatency des O- oder P-Moduls.

Wird der Ausgang eines ersten M-Moduls mit dem Eingang eines zweiten M-Moduls (Serienschaltung) verschaltet, so muss dabei die Buffer-Size des zweiten M-Moduls mindestens so groß sein wie die Output-Latency des ersten M-Moduls. Andernfalls muss ein Puffer eingefügt werden, der die überzähligen Datenworte zwischenspeichern kann, was automatisch erfolgt. Die Gesamtanordnung kann nach aktivem Inhibit-Signal nur noch so viele Daten aufnehmen wie durch die Buffer-Size des ersten M-Moduls spezifiziert ist. Die Output-Latency der Gesamtanordnung entspricht der Output-Latency des zweiten M-Moduls.

Bei Parallelschaltungen verschiedener Modultypen ist entscheidend, an die Eingänge welchen Modultyps die Ausgänge der parallel geschalteten Module wieder zusammengeführt werden.

Bei einem O- oder P-Modul müssen die CTRL-Signale aller Input-Links synchron sein. Daher gelten hier die engsten Anforderungen. So muss bei der Parallelschaltung eines ersten und mindestens eines zweiten O-Moduls, deren Ausgänge mit den Eingängen eines dritten O-oder P-Moduls verschaltet werden, hinter oder vor dem ersten oder zweiten O-Modul, je nachdem, welches die kleinere Output-Latency hat, ein Verzögerungsregister mit so vielen Stufen eingefügt werden, wie die Differenz der Output-Latencies des ersten und zweiten O-Moduls beträgt, damit an den Eingängen des dritten Moduls eine Synchronisation der Daten gewährleistet bleibt. Die Output-Latency der Gesamtanordnung entspricht dabei der Summe aus der maximalen Output-Latency der parallel geschalteten O-Module und der maximalen Output-Latency des in Serie geschalteten O- oder P-Moduls.

Eine Parallelschaltung eines ersten P- oder M-Moduls mit mindestens einem zweiten P- oder M-Modul, deren Ausgänge mit den Eingängen eines dritten O- oder P-Moduls verschaltet werden, ist nicht zulässig. Das resultiert daraus, dass P- und M-Module über keine fest definierte Latency verfügen, so dass keine Gleichphasigkeit der Daten erreicht werden kann.

Zulässig ist jedoch eine Parallelschaltung eines ersten O-, P- oder M-Moduls mit mindestens einem zweiten O-, P- oder M-Modul, wenn deren Ausgänge mit den Eingängen eines dritten M-Moduls verschaltet werden.

Bei M-Modulen können die CTRL-Signale aller Input-Links unabhängig sein. Hier sind daher alle Kombinationen zulässig. Es wird kein Latency-Ausgleich der einzelnen Pfade vorgenommen. Die Datenflusskontrolle erfolgt ausschließlich anhand der CTRL- und INH-Signale.

Das vorgeschlagene Verfahren ist unter anderem auch dadurch gekennzeichnet, dass überprüft wird, ob die Verschaltungsregeln durch die Topologie eingehalten sind. Werden Fehler erkannt, so werden diese entweder gemeldet oder die Topologie wird derart ergänzt- sofern möglich -, dass die Verschaltungsregeln erfüllt sind. Dadurch werden Design-Fehler minimiert.

Auch kann in dem vorgeschlagenen Verfahren eine Verschachtelung von Modulanordnungen erfolgen. Dabei ist die Funktions-Logik eines Moduls aus einer Anordnung mehrerer Module aufgebaut. Bei der Verschachtelung sind beliebig tiefe Strukturen möglich. Um solche Anordnungen realisieren zu können, müssen Verbindungen zwischen Input-Links und Verbindungen zwischen Output-Links zulässig sein.

Bei einer solchen Verschachtelung werden ebenfalls ggf. nötige Verzögerungselemente und Puffer automatisch eingefügt. Dadurch kann es niemals zu Datenverlusten, Datenstau oder Deadlock-Situationen kommen. Insgesamt hat das Design eine geringe Fehlerwahrscheinlichkeit.

Das erfindungsgemäße Verfahren ist so angelegt, dass die Möglichkeit besteht, eine Mehrzahl von Verschachtelungen und Verschaltungen von Modulen (Baustein) zum Realisieren jeweils einer vorgegebenen Funktion zu erstellen, woraus eine Bibliothek aufgebaut werden kann.

Zur Darstellung von Modulen für die Verarbeitung von Nutzdaten können graphische Symbole verwendet werden. Damit wird die Möglichkeit geschaffen, auf graphisch orientierter Basis eine Topologie nach dem Baukastenprinzip aus Modulen und Bausteinen aus einer Bibliothek zu erstellen.

### Graphischer Editor

Die Aufgabe wird auch gelöst durch einen graphischen Editor für die Programmierung von Hardware für die Verarbeitung von Nutzdaten mit graphischen Symbolen zur Darstellung von Modulen, wobei jedes Modul eine Funktion zum Verarbeiten der Nutzdaten ausführen kann, wenn das Modul in Hardware realisiert wird.

Der Editor hat graphische Symbole zur Darstellung von unterschiedlichen Modultypen, wobei die Module nach vorgegebenen Eigenschaften gemäß den Modultypen klassifiziert werden können.

Der Editor hat mindestens ein graphisches Symbol zur Darstellung von Schnittstellen zum Verschalten der Module. Ferner hat er Mittel zum Überprüfen, ob eine zulässige Verschaltung von Modulen gemäß vorgegebenen Verschaltungsregeln vorliegt, wobei die Verschaltungsregeln abhängig von den Modultypen derart definiert sind, dass die Steuerung des Datenflusses zwischen den verschalteten Modulen über Inhibit-Signale erfolgt. Dabei können die Inhibit-Signale von einem Modultyp erzeugt werden. Durch ein aktives Inhibit-Signal wird der Nutzdatenfluss gestoppt.

Der Editor hat graphische Mittel zum Aufbau einer graphischen Darstellung einer Verschaltung von Modulen (Topologie), die einer für die Verarbeitung der Nutzdaten geeigneten Abfolge der Funktionen entspricht. Ferner hat er Mittel zum Übersetzen der graphischen Darstellung der Topologie in eine Programmierung der Hardware.

### Computerprogramm

Ferner wird die Aufgabe gelöst durch ein Computerprogramm, das bei Ablauf auf einer Recheneinheit, einem Mikrocontroller, DSP, FPGA oder Computer oder auf einer Mehrzahl davon in einem Netzwerk das erfindungsgemäße Verfahren oder den graphischen Editor in einer ihrer Ausgestaltungen ausführt.

Weiterhin wird die Aufgabe gelöst durch ein Computerprogramm mit Programmcode-Mitteln, um das erfindungsgemäße Verfahren in einer seiner Ausgestaltungen durchzuführen oder den graphischen Editor zu realisieren, wenn das Programm auf einer Recheneinheit, einem Mikrocontroller, DSP, FPGA oder Computer oder auf einer Mehrzahl davon in einem Netzwerk ausgeführt wird. Insbesondere können die Programmcode-Mittel auf einem computerlesbaren Datenträger gespeicherte Instruktionen sein.

Außerdem wird die Aufgabe gelöst durch einen Datenträger, auf dem eine Datenstruktur gespeichert ist, die nach einem Laden in einen Arbeits- und/oder Hauptspeicher einer Recheneinheit, eines Mikrocontrollers, DSPs, FPGAs oder Computers oder einer Mehrzahl davon in einem Netzwerk das erfindungsgemäße Verfahren oder den graphischen Editor in einer ihrer Ausgestaltungen ausführen kann.

Auch wird die Aufgabe gelöst durch ein Computerprogramm-Produkt mit auf einem maschinenlesbaren Träger gespeicherten Programmcode-Mitteln, um das erfindungsgemäße Verfahren in einer seiner Ausgestaltungen durchzuführen oder den graphischen Editor zu realisieren, wenn das Programm auf einer Recheneinheit, einem Mikrocontroller, DSP, FPGA oder Computer oder auf einer Mehrzahl davon in einem Netzwerk ausgeführt wird.

Dabei wird unter einem Computer-Programmprodukt das Programm als handelbares Produkt verstanden. Es kann grundsätzlich in beliebiger Form vorliegen, so zum Beispiel auf Papier oder einem computerlesbaren Datenträger und kann insbesondere über ein Datenübertragungsnetz verteilt werden.

Schließlich wird die Aufgabe gelöst durch ein moduliertes Datensignal, welches von einer Recheneinheit, einem Mikrocontroller, DSP, FPGA oder Computer oder von einer Mehrzahl davon in einem Netzwerk ausführbare Instruktionen zum Ausführen des erfindungsgemäßen Verfahrens oder des graphischen Editors in einer ihrer Ausgestaltungen enthält.

Als Computersystem zum Ausführen des Verfahrens oder zum Realiseren des graphischen Editors kommen sowohl ein Stand-alone Computer oder Mikrocontroller, DSPs oder FPGAs in Betracht, als auch ein Netzwerk von Mikrocontrollern, DSPs, FPGAs oder Rechnern, beispielsweise ein hausinternes, geschlossenes Netz, oder auch Rechner, die über das Internet miteinander verbunden sind. Ferner kann das Computersystem durch eine Client-Server-Konstellation realisiert sein, wobei Teile der Erfindung auf dem Server, andere auf einem Client ablaufen.

### Logische Schaltung

Die Aufgabe wird auch durch eine logische Schaltung gelöst, die durch das beschriebene Verfahren in einer seiner Ausgestaltungen erhalten wird.

Ferner auch durch eine logische Schaltung für die Verarbeitung von Nutzdaten mit einer Mehrzahl von Modulen, wobei jedes Modul mindestens eine Funktion zum Verarbeiten der Nutzdaten ausführen kann. Dabei sind die Module nach vorgegebenen Eigenschaften in eine Mehrzahl von Modultypen klassifizierbar. Die logische Schaltung weist ferner vorgegebene Schnittstellen zum Verschalten der Module auf. Die Verschaltungen zwischen den Modulen sind abhängig von den Modultypen derart realisiert, dass die Steuerung des Datenflusses zwischen den verschalteten Modulen über Inhibit-Signale erfolgt, wobei die Inhibit-Signale von einem Modultyp erzeugt werden können, und wobei durch ein aktives Inhibit-Signal der Nutzdatenfluss gestoppt wird. Die logische Schaltung ist durch eine Verschaltung der Module realisiert, die einer für die Verarbeitung der Nutzdaten geeigneten Abfolge der Funktionen entspricht.

Weitere Einzelheiten und Merkmale ergeben sich aus der nachfolgenden Beschreibung von bevorzugten Ausführungsbeispielen in Verbindung mit den Unteransprüchen. Hierbei können die jeweiligen Merkmale für sich alleine oder zu mehreren in Kombination miteinander verwirklicht sein. Die Möglichkeiten, die Aufgabe zu lösen, sind nicht auf die Ausführungsbeispiele beschränkt.

Die Ausführungsbeispiele sind in den Figuren schematisch dargestellt. Gleiche Bezugsziffern in den einzelnen Figuren bezeichnen dabei gleiche oder funktionsgleiche bzw. hinsichtlich ihrer Funktionen einander entsprechende Elemente. Im Einzelnen zeigt:
Fig. 1 eine schematische Darstellung der Datenstruktur eines Input-Links und eines Output-Links;
Fig. 2 eine schematische Darstellung eines O-Moduls mit einem Input-Link;
Fig. 3 eine schematische Darstellung eines O-Moduls mit zwei Input-Links
Fig. 4 eine schematische Darstellung eines P-Moduls mit einem Input-Link;
Fig. 5 eine schematische Darstellung eines P-Moduls mit zwei Input-Links
Fig. 6 eine schematische Darstellung eines M-Moduls mit einem Input-Link;
Fig. 7 eine schematische Darstellung eines M-Moduls mit zwei Input-Links;
Fig. 8 eine schematische Darstellung der Serienschaltung des Ausgangs eines O-Moduls an den Eingang eines O-Moduls;
Fig. 9 eine schematische Darstellung der Serienschaltung des Ausgangs eines O-Moduls an den Eingang eines M-Moduls;
Fig. 10 eine schematische Darstellung der Serienschaltung des Ausgangs eines M-Moduls an den Eingang eines O-Moduls;
Fig. 11 eine schematische Darstellung der Serienschaltung des Ausgangs eines M-Moduls an den Eingang eines M-Moduls;
Fig. 12 eine schematische Darstellung der Parallelschaltung von zwei O-Modulen bei Verschaltung der Ausgänge der parallelen Module jeweils mit einem Eingang eines O-oder P-Moduls;
Fig. 13 eine schematische Darstellung der nicht zulässigen Parallelschaltung von zwei P- oder M-Modulen bei Verschaltung der Ausgänge der parallelen Module jeweils mit einem Eingang eines O- oder P-Moduls;
Fig. 14 eine schematische Darstellung der Parallelschaltung von zwei O-, P- oder M-Modulen bei Verschaltung der Ausgänge der parallelen Module jeweils mit einem Eingang eines M-Moduls;
Fig. 15 eine schematische Darstellung einer Verschachtelung von Hardwaremodulen;
Fig. 16 eine schematische Darstellung eines Beispiels für eine Verschaltung von Hardwaremodulen (Topologie);
Fig. 17 eine schematische Darstellung eines Moduls mit einem oder mehreren Input-Links;
Fig. 18 eine schematische Darstellung eines Moduls mit einem oder mehreren Output-Links;
Fig. 19 eine schematische Darstellung eines Moduls mit einem Input-Link und einem Output-Link;
Fig. 20 eine schematische Darstellung eines Moduls mit mehreren Input-Links und einem Output-Link;
Fig. 21 eine schematische Darstellung eines Moduls mit einem Input-Link und mehreren Output-Links;
Fig. 22 eine schematische Darstellung eines Moduls mit mehreren Input-Links und mehreren Output-Links;
Fig. 23 eine schematische Darstellung der Schichten der Implementierung eines Moduls;
Fig. 24 eine graphische Darstellung (Screen shot) einer beispielhaften Ausführung einer Topologie, und
Fig. 25 eine schematische Darstellung des Analysegraphen zur Topologie aus 24.

### Links

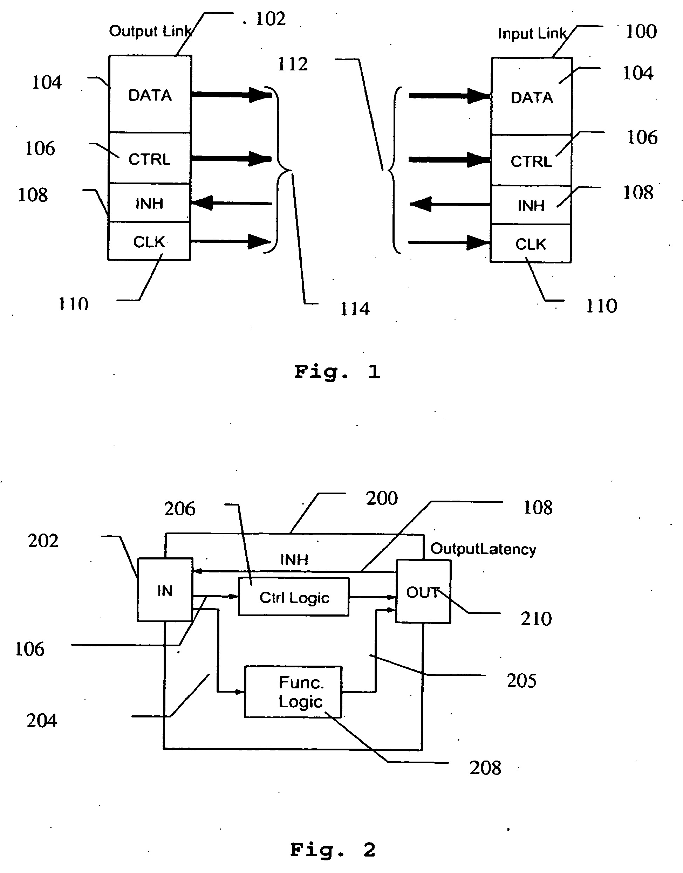

Die Fig. 1 zeigt schematisch die Datenstruktur eines Input-Links 100 bzw. eines Output-Links 102. Ein Link 100, 102 ist eine Datenstruktur, die aus Datensignalen (DATA) 104, Kontrollsignalen (CTRL) 106, einem Inhibit-Signal (INH) 108 sowie einem Taktsignal (CLK) 110 besteht.

Die Richtung des Signalflusses 112 ist bei einem Input-Link 100 dadurch charakterisiert, dass alle Daten- und Kontrollsignale 104, 106 sowie das Taktsignal 110 Eingangssignale sind, während das Inhibit-Signal 108 ein Ausgangssignal ist. Demgegenüber ist die Richtung des Signalflusses 114 bei einem Output-Link 102 dadurch charakterisiert, dass alle Daten- und Kontrollsignale 104, 106 sowie das Taktsignal 110 Ausgangssignale sind, während das Inhibit-Signal 108 ein Eingangssignal ist.

Die Datensignale 104 transportieren die Nutzdaten. Sie können beliebig aufgebaut und strukturiert sein. Insbesondere sind dabei auch verschachtelte Strukturen zulässig. Die Kontrollsignale 106 übermitteln Zusatzinformationen zeitgleich zu den Datensignalen 104. Aus den Kontrollsignalen 106 muss sich die Gültigkeit der Nutzdaten erkennen lassen. Dazu kann ein bestimmtes einzelnes Signal oder auch eine Kombination mehrerer Signale genutzt werden.

### O-Modul

In Fig. 2 wird die Verarbeitung der in der Datenstruktur eines Input-Links 100 enthaltenen verschiedenen Signale durch ein OModul 200 mit einem Input-Link 202 gezeigt.

Der Datenfluss der am Input-Link 202 des O-Moduls 200 anliegenden Kontrollsignale 106 wird durch das O-Modul 200 nicht beeinflusst. Der Nutzdatenfluss wird jedoch verändert. Dabei erfahren die Nutzdaten 104 beim Durchlaufen des Moduls 200 eine genau definierte Verzögerung (Latency). Diese entspricht in der Regel der Anzahl der Registerstufen, die die Nutzdaten auf den Datenwegen 204, 205 über die Funktions-Logik 208 vom Input-Link 202 zum Output-Link 210 durchlaufen. Das O-Modul 200 kann nach Stoppen des Eingangsdatenflusses 104 noch maximal so viele Daten liefern, wie durch die Output-Latency bestimmt wird.

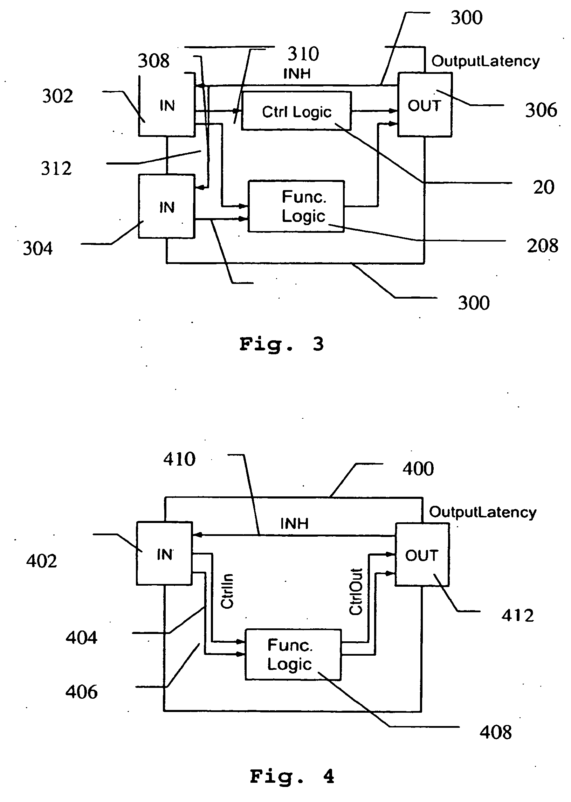

Fig. 3 zeigt ergänzend die Besonderheiten eines O-Moduls mit mehreren Input-Links 302 und 304. Bei dieser Ausführung des OModuls 300 müssen die Daten gleichphasig anliegen. Es wird davon ausgegangen, dass die CTRL-Signale 106 einschließlich Data-Valid aus derselben Quelle stammen. Daraus resultiert, dass die automatisch erzeugte CTRL-Logic 206 nur aus einem beliebig gewählten der Input-Links 302 oder 303, beispielsweise 302, gespeist werden muss. Das Inhibit-Signal wird über die Datenwege 310, 312 identisch auf die Input-Links 302, 304 geleitet.

### P-Modul

Fig. 4 zeigt die Verarbeitung der in der Datenstruktur eines Input-Links 100 enthaltenen verschiedenen Signale durch ein P-Modul 400 mit einem Input-Link 402 gezeigt.

Der Datenfluss der am Input-Link 402 des P-Moduls 400 anliegenden Kontrollsignale 106 kann durch das P-Modul 400 beeinflusst werden, jedoch nur indem die absolute Datenrate reduziert wird. Die Datenwege 404, 406 sowohl der Kontrolldaten 106 als auch der Nutzdaten 104 verlaufen daher beim P-Modul über die Funktions-Logik 408.

Die Anzahl und die zeitliche Lage der Kontrollsignale 106 einschließlich Data-Valid kann sich damit verändern. Das hat zur Folge, dass das P-Modul 400 insbesondere weniger Datenworte liefern kann als es empfängt. Das Inhibit-Signal 108 wird in der Funktions-Logik 408 verarbeitet. Der Datenweg 410 des Inhibit-Signals verläuft direkt vom Output-Link 412 zum Input-Link 402 des P-Moduls, woraus resultiert, das das Inhibit-Signal 108 in der Funktions-Logik 408 des P-Moduls 400 nicht genutzt wird.

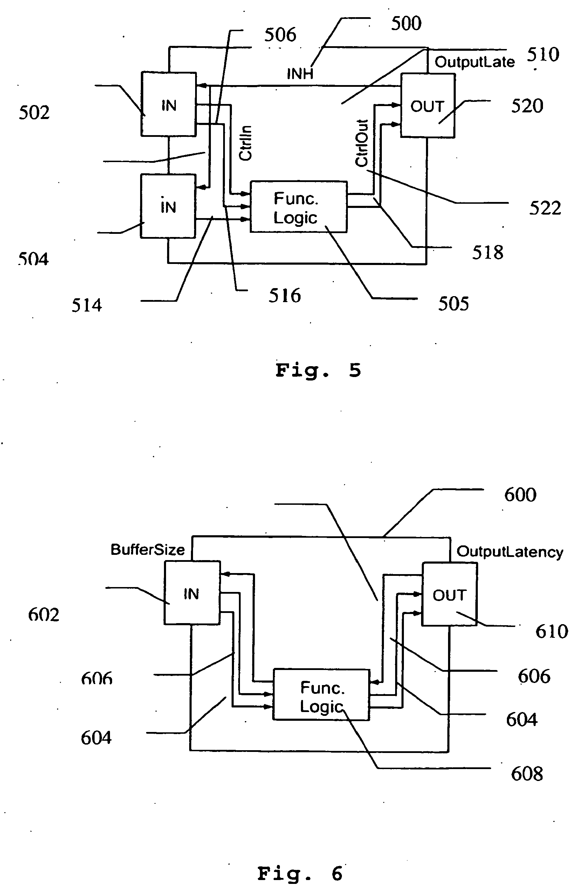

Bei einem in Fig. 5 dargestellten P-Modul 500 mit mehreren Eingängen wird angenommen, dass die an den Input-Links 502 und 504 anliegenden Kontrollsignale aus einer Quelle stammen. Die Funktions-Logik 505 wird daher nur aus einem beliebig gewählten der Input-Links 502 oder 504, beispielsweise 502, über den Datenweg 506, gespeist. Das Inhibit-Signal 108 wird identisch über die Datenwege 510, 512 auf die Input-Links 502, 504 geleitet. Bei dieser Ausführung des P-Moduls 500 müssen die Daten gleichphasig anliegen. Die Nutzdaten werden über die Datenwege 514, 516 zur Funktions-Logik und weiter über den Datenweg 518 zum Output-Link 520 geführt, während die Kontrollsignale 106 über den Datenweg 522 zum Output-Link geführt werden.

### M-Modul

Ein in Fig. 6 dargestelltes M-Modul 600 kann den Kontrollfluss massiv beeinflussen, ja sogar vollständig anhalten. Vom Input-Link 602 des Moduls 600 verlaufen die Datenwege 604, 606 der Nutz- und Kontrolldaten 104 bzw. 106 über die Funktions-Logik 608 zum Output-Link 610 des M-Moduls 600. Der Datenweg 611 des Inhibit-Signals verläuft vom Output-Link 610 über die Funktions-Logik 608 zum Input-Link 602. Das M-Modul 600 kann nach dem Stoppen des Datenflusses maximal eine solche Anzahl Datenworte aufnehmen, wie sie durch die Größe des am Input-Link des Moduls vorhanden Puffers (Buffer-Size) bestimmt wird.

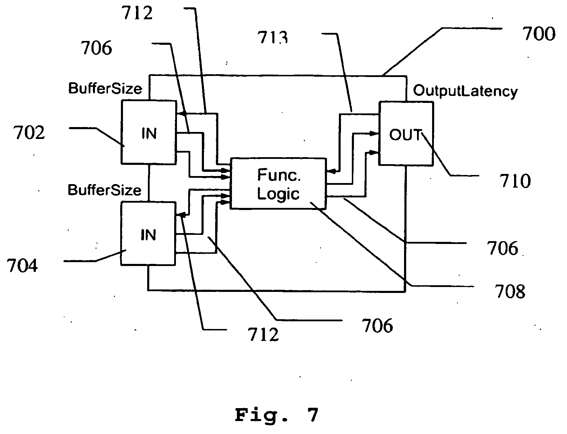

Bei einem M-Modul 700 entsprechend Fig. 7 mit mehreren Input-Links 702, 704 wird davon ausgegangen, dass die Kontrollsignale aus unabhängigen Quellen stammen können. Daher werden die Kontrollsignale 106 von allen Input-Links 702, 704 über die Datenwege 706 zur Funktions-Logik 708 und weiter zum Output-Link 710 des M-Moduls 700 geführt. Ebenso werden die Inhibit-Signale 108 über die Datenwege 712 vom Output-Link 710 zu den Input-Links 702, 704 geführt. Die Funktions-Logik 708 realisiert die korrekte Bearbeitung und evtl. Zwischenspeicherung versetzt eingehender Daten.

### Verschaltung

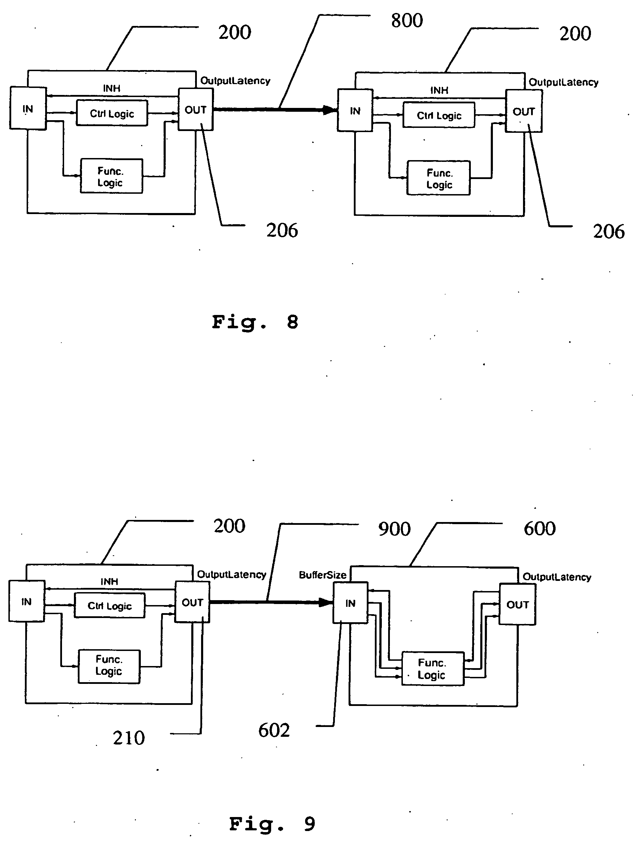

Fig. 8 zeigt eine Serienschaltung von zwei O-Modulen 200. Der Ausgang 206 des ersten O-Moduls 200 ist über den Datenweg 800 mit dem Eingang 202 des zweiten O-Moduls 200 verschaltet. Die Output-Latency der gesamten Schaltungsanordnung ergibt sich aus der Summe der Output-Latencies der einzelnen Module. Die Gesamtanordnung kann nach aktivem Inhibit-Signal noch beliebig viele Daten aufnehmen.

Fig. 9 zeigt eine Serienschaltung eines O-Moduls 200 mit einem M-Modul 600. Dabei ist der Ausgang 210 des O-Moduls 200 über den Datenweg 900 mit dem Eingang 602 des M-Moduls verschaltet. Die Puffergröße am Input-Link 602 des M-Moduls 600 muss bei dieser Verschaltung mindestens so groß sein wie die Output-Latency des O-Moduls. Andernfalls muss ein Puffer eingefügt werden, der die überzähligen Datenworte zwischenspeichern kann. Dieses wird automatisch durchgeführt. Die Gesamtanordnung kann nach aktivem Inhibit-Signal nur noch so viele Daten aufnehmen, wie durch Buffer-Size am Input-Link 602 und einen eventuell eingefügten Puffer spezifiziert ist. Die Output-Latency dieser Gesamtanordnung entspricht der Output-Latency des M-Moduls 600.

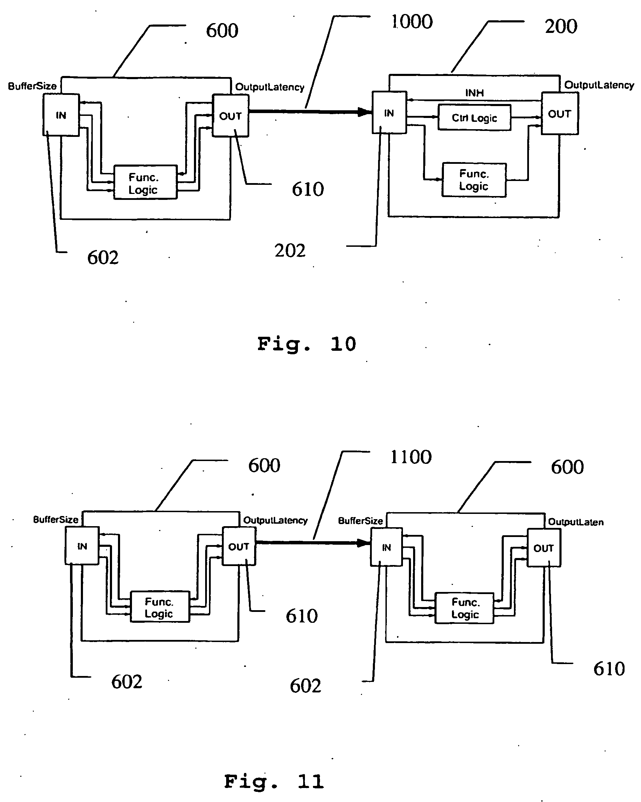

Fig. 10 zeigt die Serienschaltung eines M-Moduls 600 mit einem O-Modul 200. Dabei ist der Ausgang 610 des M-Moduls 600 über den Datenweg 1000 mit dem Eingang 202 des O-Moduls verschaltet. Die Gesamtanordnung kann nach aktivem Inhibit-Signal nur noch so viele Daten aufnehmen, wie durch die Buffer-Size am Eingang 602 der Gesamtanordnung spezifiziert ist. Die Output-Latency der Gesamtanordnung ergibt sich aus der Summe der Output-Latencies der einzelnen Module.

In Fig. 11 wird die Serienschaltung eines ersten M-Moduls 600 mit einem zweiten M-Modul 600 gezeigt. Dabei ist der Ausgang 610 des ersten M-Moduls 600 über den Datenweg 1100 mit dem Eingang 602 des zweiten M-Moduls verschaltet. Die Buffer-Size am Input-Link 602 des zweiten M-Moduls 600 muss dabei mindestens so groß sein wie die Output-Latency am Output-Link 610 des ersten M-Moduls. Die Gesamtanordnung kann nach aktivem Inhibit-Signal nur noch so viele Daten aufnehmen, wie durch die Buffer-Size am Input-Link 602 des ersten M-Moduls spezifiziert ist. Die Output-Latency dieser Gesamtanordnung entspricht der Output-Latency des zweiten M-Moduls 600.

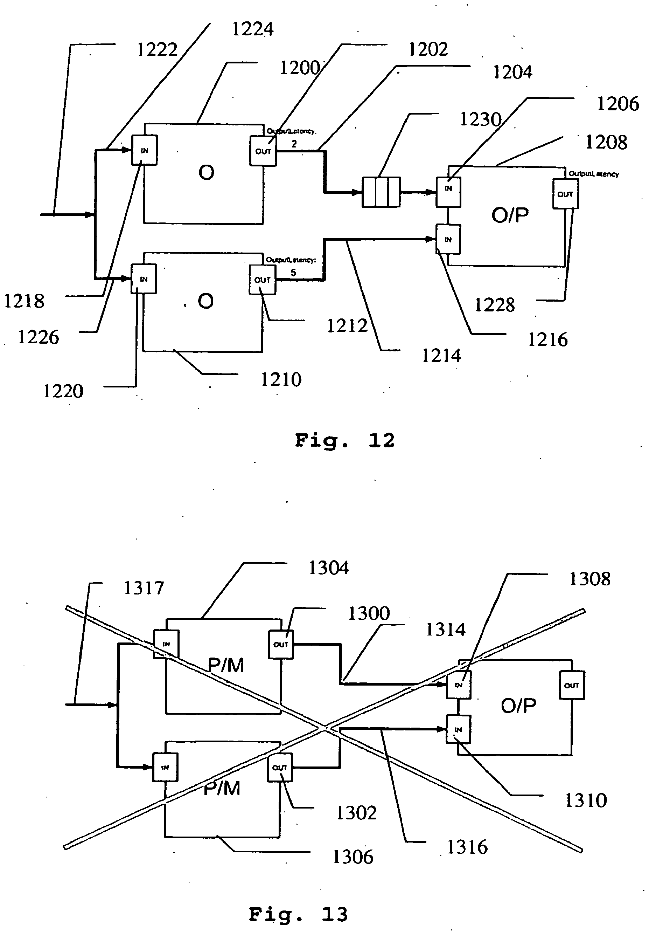

Fig. 12 zeigt die Parallelschaltung von zwei O-Modulen. Dabei wird ein erster O-Modul 1200 mit seinem Ausgang 1202 über den Datenweg 1204 mit einem ersten Eingang 1206 eines zweiten O- oder P-Moduls 1208 verschalten. Ein zweiter O-Modul 1210 wird parallel dazu mit seinem Ausgang 1212 über den Datenweg 1214 mit einem zweiten Eingang 1216 des Moduls 1208 verschalten. Die Eingänge 1218 und 1220 der beiden parallelen O-Module 1200 und 1210 werden über die Datenwege 1222, 1224, 1226 gespeist. Bei einem O- oder P-Modul müssen die CTRL-Signale aller Input-Links synchron sein. Daher gelten bei dieser Anordnung die engsten Anforderungen. Die Output-Latency am Ausgang 1228 der Gesamtanordnung ergibt sich aus der Summe der maximalen Output-Latencies der Parallelschaltung und der maximalen Output-Latency des in Serie geschalteten O- oder- P-Moduls. Die Gesamtanordnung kann nach aktivem Inhibit-Signal noch beliebig viele Daten aufnehmen. Hinter dem Modul mit der kleineren Output-Latency muß zum Ausgleich ein Register 1230 mit so vielen Stufen eingefügt werden, wie die Differenz zur maximalen Output-Latency beträgt. Im dargestellten Beispiel sind dies drei Registerstufen.

Die in Fig. 13 dargestellte Anordnung zeigt die Verschaltung der Ausgänge 1300, 1302 von zwei parallel angeordneten P- und/oder M-Modulen 1304, 1306 mit jeweils einem Eingang 1308, 1310 eines O- oder P-Moduls 1312 über die Datenwege 1314, 1316. Die parallel geschalteten Module werden aus derselben Datenquelle über den Datenweg 1317 gespeist. Eine solche Anordnung ist nicht zulässig, da die P- bzw. M-Module 1304, 1306 über keine fest definierte Verzögerung verfügen, so dass keine Gleichphasigkeit der Daten an den Ausgängen 1300, 1302 der beiden parallel geschalteten P- oder M-Module 1304, 1306 bzw. an den Eingängen 1308 und 1310 des nachgelagerten O/P-Moduls erreicht werden kann. Diese Schaltung ist deshalb nicht zulässig, weil die beiden parallel geschalteten P- oder M-Module 1304, 1306 aus der gleichen Datenquelle gespeist wird. In diesem Falle kann es zu einem Deadlock kommen.

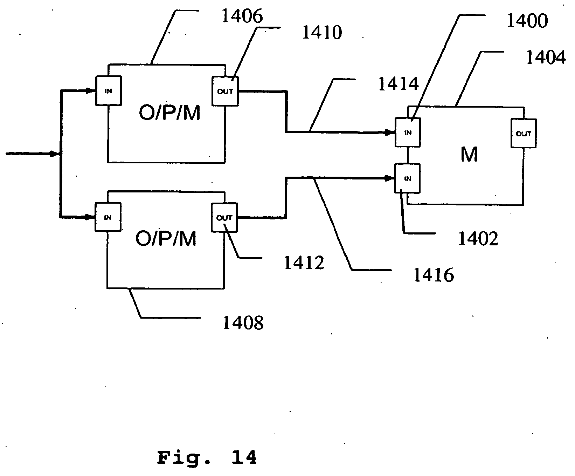

Sind die Datenquellen der parallel geschalteten Module unabhängig voneinander, so ist diese Zusammenführung in einem Sonderfall erlaubt. Dazu wird ein Synchronisierungsmodul benötigt, das beide Datenströme gleichphasig macht.
Bei der in Fig. 14 dargestellten Anordnung können die Kontrollsignale aller Input-Links an den Eingängen 1400, 1402 des M-Moduls 1404 unabhängig voneinander sein. Hier sind die Parallelschaltungen aller Kombinationen von O- und/oder P- und/oder M-Modulen 1406,1408 möglich, deren Ausgänge 1410, 1412 über die Datenwege 1414, 1416 an den Eingängen 1400, 1402 des M-Moduls 1404 zusammen geführt werden. Wie oben beschrieben wird bei dieser Variante der parallelen Verschaltung von Modulen kein Latency-Ausgleich der einzelnen Pfade vorgenommen. Die Datenflusskontrolle erfolgt hier ausschließlich anhand der CTRL- und INH-Signale.

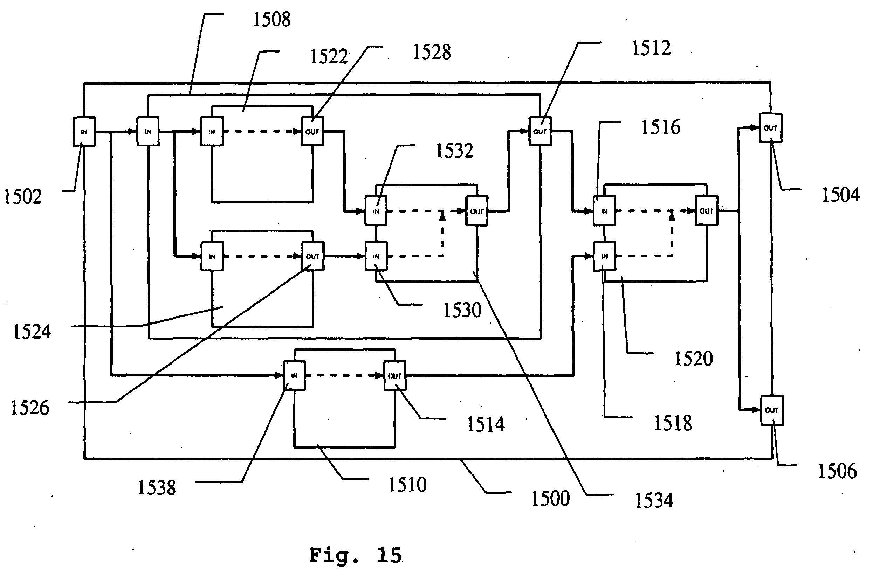

Fig. 15 zeigt schematisch ein Beispiel für die Verschachtelung von Modulanordnungen. Das Modul 1500 besitzt einen Eingang 1502 und zwei Ausgänge 1504, 1506. Das Modul 1500 enthält eine verschachtelte Anordnung von zwei parallel verschalteten Modulen 1508, 1510, deren jeweiliger Ausgang 1512, 1514 mit den Eingängen 1516, 1518 eines dritten Moduls 1520 verschaltet sind. Bei dieser Anordnung enthält das Modul 1508 wiederum eine Parallelschaltung von zwei Modulen 1522, 1524, deren Ausgänge 1526, 1528 mit den Eingängen 1530, 1532 eines dritten Moduls 1534 zusammengeschaltet sind.

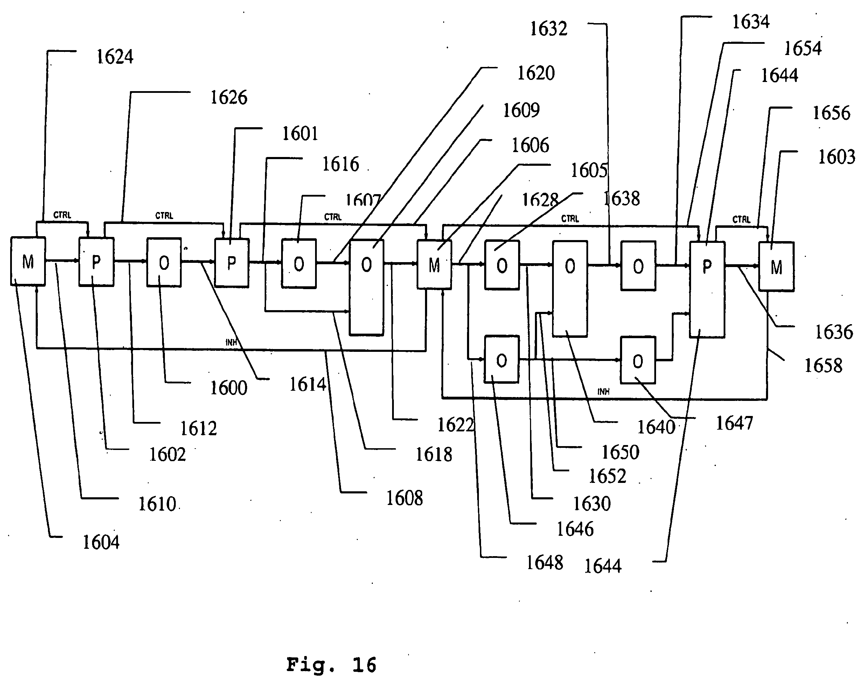

Ein Beispiel einer Topologie von Modulen wird schematisch in Fig. 16 dargestellt.

Hierbei wird eine Topologie mit einer Mehrzahl von O-, P- und M-Modulen gezeigt. Der Datenfluss verläuft vom M-Modul 1604 über die Datenwege 1610, 1612, 1614 1616, 1618, 1620 und 1622 zum M-Modul 1605. Dabei sind in der Reihenfolge M-Modul 1604, P-Modul 1602, O-Modul 1600, P-Modul 1601, O-Modul 1607, O-Modul 1609 und M-Modul 1605 über diese Datenwege seriell miteinander verschaltet. Zwischen P-Modul 1601 und O-Modul 1607 verzweigt sich der Datenweg und verläuft über Datenweg 1618 zu einem zweiten Eingang des O-Moduls 1609. Die CTRL-Signale verlaufen vom M-Modul 1604 über den Datenweg 1624 zum P-Modul 1602, vom

P-Modul 1602 über den Datenweg 1626 zum P-Modul 1601, von diesem über den Datenweg 1606 zum M-Modul 1605. Ein Inhibit-Signal verläuft über den Datenweg 1608 vom M-Modul 1605 zum M-Modul 1604. Vom M-Modul 1605 verläuft der Datenfluss über die Datenwege 1628, 1630, 1632, 1634 und 1636 zum M-Modul 1603. Dabei sind in der Reihenfolge M-Modul 1605, O-Modul 1638, O-Modul 1640, O-Modul 1642, P-Modul 1644 und M-Modul 1603 über diese Datenwege seriell miteinander verschaltet. Zwischen dem M-Modul 1605 und dem O-Modul 1638 erfolgt über den Datenweg 1648 eine Verzweigung des Datenflusses zum O-Modul 1646. Eine weitere Verzweigung erfolgt zwischen den O-Modulen 1646 und 1647 über den Datenweg 1652 zum O-Modul 1640. Vom O-Modul 1646 verläuft der Datenfluss über den Datenweg 1650 zum O-Modul 1647 und weiter über den Datenweg 1652 zum P-Modul 1644. Vom P-Modul verläuft der Datenfluss über den Datenweg 1636 zum M-Modul 1603. Die CTRL-Signale verlaufen vom M-Modul 1605 zum P-Modul 1644 sowie vom P-Modul 1644 zum M-Modul 1603. Das Inhibit-Signal wird über den Datenweg 1658 vom M-Modul 1603 zum M-Modul 1605 übertragen.

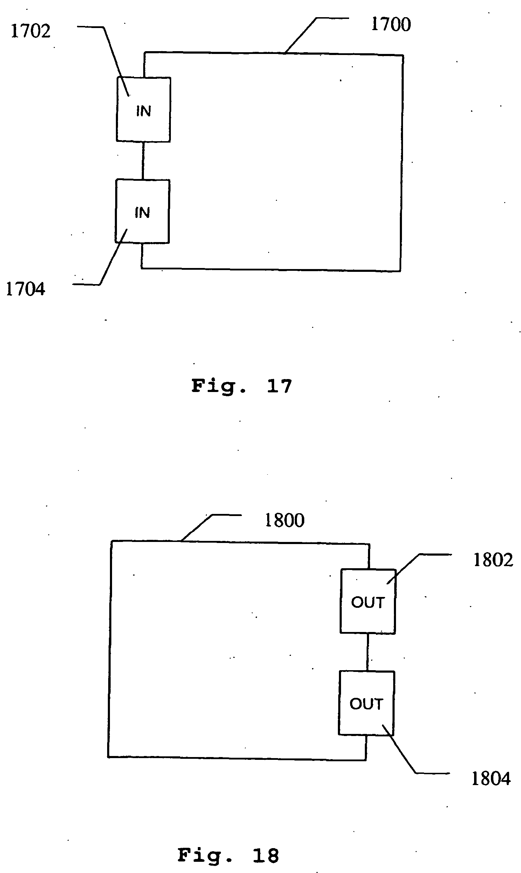

Für die Relation von Links zu Modulen werden die verschiedenen möglichen Konfigurationen in den Fig. 17 bis 22 schematisch gezeigt.

Fig. 17 zeigt ein Modul 1700, welches nur einen oder mehrere Input-Links 1702, 1704 hat. Hierbei handelt es sich um Module, die nur Daten aufnehmen können. Das kann beispielsweise ein DMA-Kanal (direct memory access) sein. Das Modul stellt eine Datensenke dar.

Ein Modul 1800 mit nur einem oder mit mehreren Output-Links 1802, 1804 wird in Fig. 18 gezeigt. Beispielsweise kann das eine Kamera sein, also eine Datenquelle.

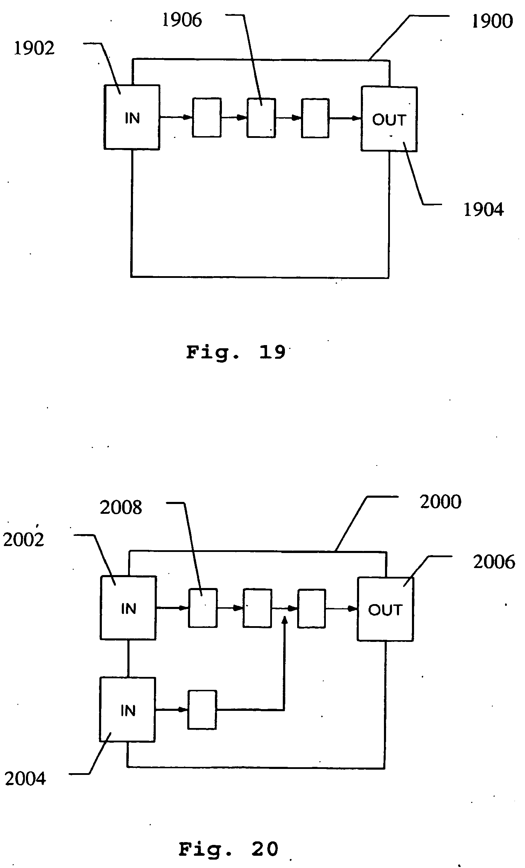

In Fig. 19 wird ein Modul 1900 mit einem Input-Link 1902 und einem Output-Link 1904 gezeigt. Diese Module empfangen in der Regel Daten von einer Quelle, bearbeiten diese und geben sie an den Ausgang weiter, wobei sie mit unterschiedlich großer Verzögerung 1906 an den Ausgang 1904 weiter gegeben werden. Es sind aber auch Module möglich, bei denen der Input- und der Output-Link unabhängig voneinander sind. Das können beispielsweise Module sein, die einen Write- und einen Read-DMA-Kanal realisieren.

Eine andere Konfiguration ist ein Modul 2000 mit mehreren Input-Links 2002, 2004 und nur einem Output-Link 2006. Diese Konfiguration wird schematisch in Fig. 20 gezeigt. Diese Module 2000 empfangen in der Regel Daten von mehreren Pfaden, bearbeiten diese und geben sie mit einer möglicherweise erforderlichen Verzögerung 2008 an den Ausgang weiter. Die Daten können dabei aus derselben Quelle stammen oder völlig unabhängig voneinander sein. Es sind beispielsweise auch Module möglich, bei denen nicht alle Input-Links eine Verbindung zum Output-Link besitzen, sondern unabhängige Datensenken darstellen.

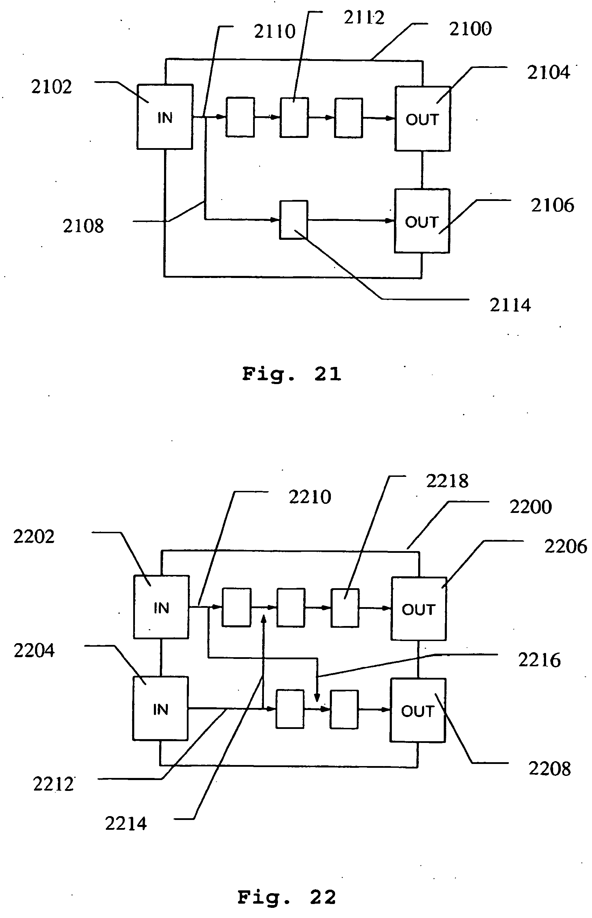

Fig. 21 zeigt als eine weitere mögliche Konfiguration ein Modul 2100 mit einem Input-Link 2102 und mehreren Output-Links 2104, 2106. Bei diesen Modulen 2100 werden in der Regel Daten von einem Eingang 2102 empfangen und über verschiedene interne Datenwege 2108, 2110 verarbeitet. Die Ergebnisse aller Datenwege werden jeweils über einen eigenen Ausgang ausgegeben. Die Verzögerung 2112, 2114 auf den Datenwegen 2108, 2110 und damit die Output-Latency kann für die einzelnen Output-Links 2104, 2106 unterschiedlich sein. Es sind aber auch Module möglich, bei denen einzelne Output-Links nicht aus Input-Links gespeist werden, sondern unabhängige Datenquellen darstellen.

Fig. 22 zeigt als letzte Konfigurationsmöglichkeit ein Modul 2200 mit mehreren Input-Links 2202, 2204 und mehreren Output-Links 2206, 2208. Daten werden von mehreren Eingängen empfangen und über verschiedene interne Datenwege 2210, 2212 verarbeitet. Die Ergebnisse aller Datenwege werden jeweils über einen eigenen Ausgang ausgegeben. Die internen Datenwege können dabei unabhängig voneinander arbeiten oder auch über Querverbindungen 2214, 2216 Daten austauschen. Die Verzögerung 2218 auf den Datenwegen und damit die Output-Latency kann für die einzelnen Output-Links 2206, 2208 unterschiedlich sein. Es sind auch einzelne unabhängige Input- und Output-Links möglich.

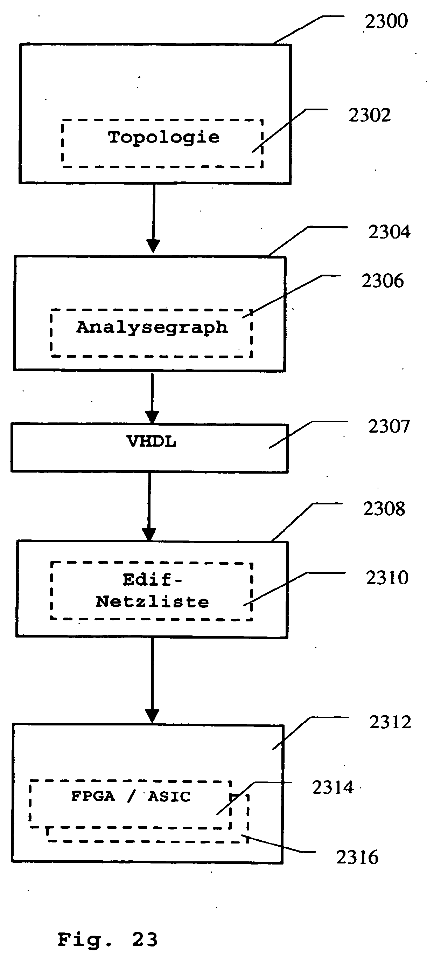

Wie in Fig. 23 gezeigt wird, kann die Implementierung eines Moduls in vier Schichten dargestellt werden.

Auf der Beschreibungsschicht 2300 wird eine Topologie 2302 erstellt. Das erfolgt auf graphischer Basis graphisch oder textuell. Auf der Beschreibungsschicht 2300 sind insbsondere folgende Informationen relevant:
- die parametrisierbare Beschreibung des Moduls, das dann später synthetisiert d.h. auf die Hardware übersetzt wird;.
- eine Simulationsbeschreibung des Moduls;
- eine Beschreibung der formalen Schnittstelle (Links, Parameter, Format, Bereichsgrenzen etc.))
- eine Beschreibung der Zugriffsschnittstelle in Hardware, d.h. welche Parameter/Register kann der Anwender während der Laufzeit in Modul verändern und wie.

Auf der Kodierungsschicht 2304 wird werden die Implementierungen der Hardwareschaltungen in einer Hardwarebeschreibungssprache, beispielsweise VHDL, erzeugt. Es ist auch möglich, die Hardwarebeschreibung in anderen Hardwarebeschreibungssprachen zu erzeugen. Dazu werden jeweils die entsprechenden Compiler benötigt, um die Beschreibung der Implementierungen in eine Edif-Netzliste zu übersetzen. Innerhalb der Kodierungsschicht wird auch der Analysegraph 2306 gebildet, der u.a. auf der Grundlage der im Programm hinterlegten Rechenregeln die Berechnung von evtl. erfoderlichen Puffern realisiert.

Aus der stark parametrisierten Hardwarebeschreibung der Kodierungsschicht 2304 werden in der Syntheschicht 2308 die Edif-Netzlisten 2310 generiert. Ist eine Edif-Netzliste 2310 erzeugt, dann werden bei FPGAs die Place-Route Werkzeuge der FPGA-Hersteller verwendet, um daraus eine Konfiguration zu erzeugen, die den gewünschten Algorithmus ausführt. Diese wird in Form von Masken für den Herstellungsprozess umgewandelt. Im Falle von ASICs sind es die entsprechenden Place, Route und Mapwerkzeuge der entsprechenden ASIC-Fabs.

In der Schicht der Hardwareimplementierung 2312 wird für das FPGA 2314 das in der Syntheseschicht erzeugte fertige FPGA-Programm bzw. Bitstrom (je nach FPGA-Gattung auch beliebig oft) geladen und führt die Schaltung aus. Der ASIC 2316 wird entsprechend der in der Synthese berechneten Masken gefertigt und führt den spezifizierten Algorithmus aus.

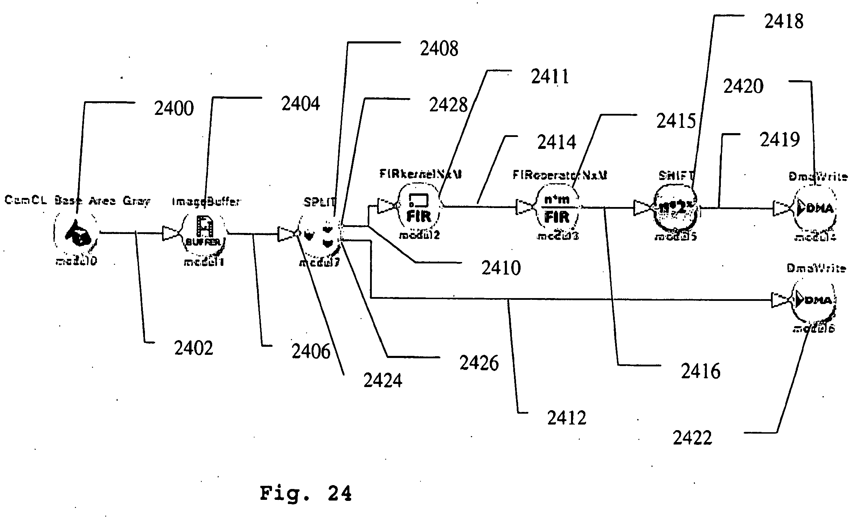

Fig. 24 zeigt eine beispielhafte Darstellung des Screenshots für eine Topologie aus Anwendersicht.
Ein Kamera-Datenfluss von Modul 2400 wird über den Datenweg 2402 zu Modul 2404 übertragen und dort gepuffert. Über den Datenweg 2406 wird der Datenfluss weiter zu Modul 2408 übertragen und dort geteilt. Über die Datenwege 2410, 2414, 2416, 2419, wird der eine Datenfluss der Reihe nach über die Module 2411, 2415 zu einem Shift-Operator 2418 geführt, hier verkleinert und dem DMA-Kanal 2420 eines PC zugeführt. Der zweite Datenfluss wird original über den Datenweg 2412 direkt an einen zweiten DMA-Kanal 2422 weitergegeben. Die Darstellungen der Module auf der Grafik zeigen auch die graphischen Symbole der Inputlinks z. B. 2424 sopwie der Output-Links z. B. 2426, 2428, von welchen aus die verschiedenen Datenwege verlaufen.

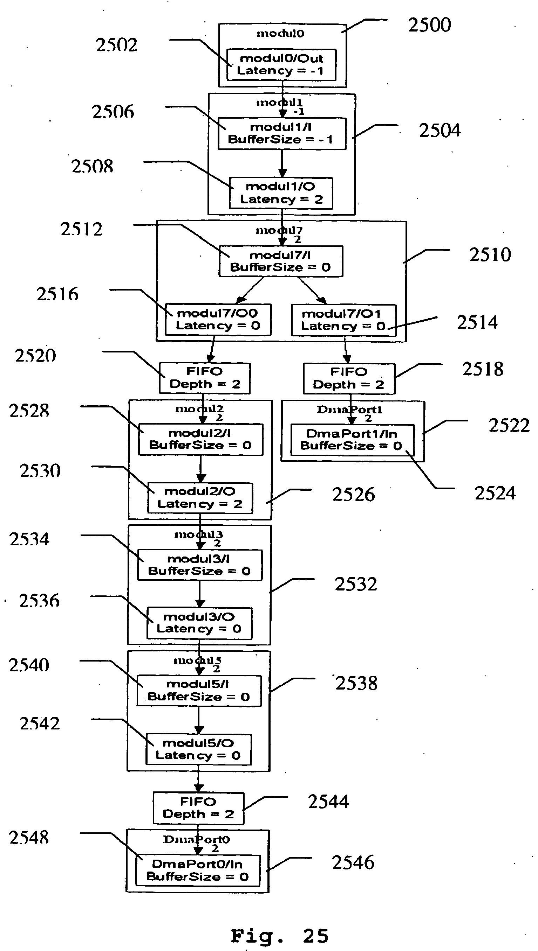

Fig. 25 zeigt den Analysegraphen zu der in Fig. 24 dargestellten Topologie.

Von einem M-Modul 2500 mit einer Output-Latency 2502 des Wertes -1 werden Daten zu einem nächsten M-Modul 2504 mit einer Buffer-Size 2506 von -1. Das bedeutet in diesem Falle, dass der Datenstrom zwischen den beiden Modulen nicht angehalten werden.

Von dem M-Modul 2504 mit einer Output-Latency 2508 des Wertes 2 werden die Daten zu einem nächsten O-Modul 2510 mit einer Buffersize 2512 des Wertes 0 übertragen. In diesem O-Modul 2510 wird der Datenfluss geteilt und über die Output-Links 2514, 2516 zu den M-Modulen 2522 bzw. 2526 übertragen. Auf der Basis der Rechenregeln des Regelwerkes wurde in diesem Falle eine erforderliche zusätzliche Puffertiefe von 2 errechnet. Im Ergebnis dessen wurden die Module 2518 bzw. 2520 automatisch zwischen dem O-Modul 2510 und den M-Modulen 2528 bzw. 2524 eingefügt. Die Module 2518 bzw. 2520 stellen FIFO-Elemente dar mit einer jeweiligen Puffertiefe des Wertes 2.

Nach der Verzweigung verläuft der eine Datenfluss weiter vom M-Modul 2526 mit einer Output-Latency 2530 des Wertes 2 zum O-Modul 2532 mit einer Buffer-Size 2534 von 0 und einer Output-Latency 2536 von 0. Weiter verläuft der Datenfluss vom O-Modul 2538 mit einer Buffer-Size 2540 von 0 und einer Output-Latency 2542 von 0 zum M-Modul 2546 mit einer Buffersize 2548 von 0. Auf der Basis der Rechenregeln des Regelwerkes wurde in diesem Falle eine erforderliche zusätzliche Puffertiefe von 2 zwischen den Modulen 2538 und 2546 ermittelt. Im Ergebnis dessen wurde das Modul 2544 mit einer Puffertiefe von 2 automatisch zwischen den Modulen 2538 und 2546 eingefügt. Der zweite Datenfluss erfolgt vom O-Modul 2510 über das automatisch eingefügte Modul 2518 direkt zum M-Modul 2522 mit der Buffer-Size 2524 von 0 realisiert.

### Bezugszeichen

- 100: Input-Link
- 102: Output-Link
- 104: Datensignal (DATA)
- 106: Kontrollsignal (CTRL)
- 108: Inhibit-Signal (INH)
- 110: Taktsignal (CLK)
- 200: O-Modul
- 202: Input-Link
- 204: Datenweg
- 205: Datenweg
- 206: CTRL-Logic
- 208: Funktions-Logik
- 210: Output-Link
- 300: O-Modul mit mehreren Input-Links
- 302: Input-Link
- 304: Input-Link
- 306: Kontrollsignal (CTRL)
- 310: Datenweg
- 312: Datenweg
- 400: P-Modul
- 402: Input-Link
- 404: Datenweg
- 406: Datenweg
- 408: Funktions-Logik
- 410: Datenweg
- 412: Output-Link
- 500: P-Modul mit mehreren Input-Links
- 502: Input-Link
- 504: Input-Link
- 505: Funktions-Logik
- 506: Datenweg
- 510: Datenweg
- 512: Datenweg
- 514: Datenweg
- 516: Datenweg
- 518: Datenweg
- 520: Output-Link
- 522: Datenweg
- 600: M-Modul
- 602: Input-Link
- 604: Datenweg
- 606: Datenweg
- 608: Funktions-Logik
- 610: Output-Link
- 700: M-Modul mit mehreren Input-Links
- 702: Input-Link
- 704: Input-Link
- 706: Datenweg
- 708: Funktions-Logik 710 Output-Link
- 712: Datenweg
- 800: Datenweg
- 900: Datenweg
- 1000: Datenweg
- 1100: Datenweg
- 1200: O-Modul
- 1202: Ausgang eines Moduls
- 1204: Datenweg
- 1206: Eingang eines Moduls
- 1208: Eingang eines Moduls
- 1210: O-Modul
- 1212: Ausgang eines Moduls
- 1214: Datenweg
- 1216: Eingang eines Moduls
- 1218: Eingang eines Moduls
- 1220: Eingang eines Moduls
- 1222: Datenweg
- 1224: Datenweg
- 1226: Datenweg
- 1228: Ausgang eines Moduls
- 1300: Ausgang eines Moduls
- 1302: Ausgang eines Moduls
- 1304: M-Modul
- 1306: M-Modul
- 1308: Eingang eines Moduls
- 1310: Eingang eines Moduls
- 1312: P-Modul
- 1314: Datenweg
- 1316: Datenweg
- 1317: Datenweg
- 1400: Eingang eines Moduls
- 1402: Eingang eines Moduls
- 1404: M-Modul
- 1406: O- oder P-Modul
- 1408: O- oder P-Modul
- 1410: Ausgang eines Moduls
- 1412: Ausgang eines Moduls
- 1414: Datenweg
- 1416: Datenweg
- 1500: Modul
- 1502: Eingang eines Moduls
- 1504: Ausgang eines Moduls
- 1506: Ausgang eines Moduls
- 1508: Modul
- 1510: Modul
- 1512: Ausgang eines Moduls
- 1514: Ausgang eines Moduls
- 1516: Eingang eines Moduls
- 1518: Eingang eines Moduls
- 1520: Modul
- 1522: Modul
- 1524: Modul
- 1526: Ausgang eines Moduls
- 1528: Ausgang eines Moduls
- 1530: Eingang eines Moduls
- 1532: Eingang eines Moduls
- 1534: Modul
- 1600: O-Modul
- 1602: P-Modul
- 1603: M-Modul
- 1604: M-Modul
- 1605: M-Modul
- 1606: Signalfluss CTRL
- 1607: O-Modul
- 1608: Signalfluss INH
- 1610: Signalfluss DATA
- 1612: Signalfluss DATA
- 1614: Signalfluss DATA
- 1616: Signalfluss DATA
- 1618: Signalfluss DATA
- 1620: Signalfluss DATA
- 1622: Signalfluss DATA
- 1624: Signalfluss CTRL
- 1626: Signalfluss CTRL
- 1628: Signalfluss DATA
- 1630: Signalfluss DATA
- 1632: Signalfluss DATA
- 1634: Signalfluss DATA
- 1636: Signalfluss DATA
- 1638: O-Modul
- 1640: O-Modul
- 1642: O-Modul
- 1644: P-Modul
- 1646: O-Modul
- 1648: O-Modul
- 1650: Signalfluss DATA
- 1652: Signalfluss DATA
- 1654: Signalfluss CTRL
- 1656: Signalfluss CTRL
- 1658: Signalfluss INH
- 1700: Modul
- 1702: Input-Link
- 1704: Input-Link
- 1800: Modul
- 1802: Output-Link
- 1804: Output-Link
- 1900: Modul
- 1902: Input-Link
- 1904: Output-Link
- 1906: Verzögerung (Latency)
- 2000: Modul
- 2002: Input-Link
- 2004: Input-Link
- 2006: Output-Link
- 2008: Verzögerung (Latency)
- 2100: Modul
- 2102: Input-Link
- 2104: Output-Link
- 2106: Output-Link
- 2108: Datenweg
- 2110: Datenweg
- 2112: Verzögerung (Latency)
- 2114: Verzögerung (Latency)
- 2200: Modul
- 2202: Input-Link
- 2204: Input-Link
- 2206: Output-Link
- 2208: Output-Link
- 2210: Datenweg
- 2212: Datenweg
- 2214: Datenweg (Querverbindung)
- 2216: Datenweg (Querverbindung)
- 2218: Verzögerung (Latency)
- 2300: Beschreibungsschicht
- 2302: Topologie
- 2304: Kodierungsschicht
- 2306: Analysegraph
- 2308: Syntheseschicht
- 2310: Edif-Netzliste
- 2312: Hardware-Implementierungsschicht
- 2314: FPGA
- 2316: ASIC
- 2400: Modul
- 2402: Datenweg
- 2404: Modul
- 2406: Datenweg
- 2408: Modul
- 2410: Datenweg
- 2411: Modul
- 2412: Datenweg
- 2414: Datenweg
- 2415: Modul
- 2416: Datenweg
- 2418: Shift-Operator
- 2419: Datenweg
- 2420: DMA-Kanal eines PC
- 2422: DMA-Kanal
- 2424: Input-Link
- 2426: Output-Link
- 2428: Output-Link
- 2500: Modul
- 2502: Output-Latency
- 2504: Modul
- 2506: Buffer-Size
- 2508: Output-Latency
- 2510: Modul
- 2512: Buffer-Size
- 2514: Output-Link
- 2516: Output-Link
- 2518: Modul
- 2520: Modul
- 2522: Modul
- 2524: Buffer-Size
- 2526: Modul
- 2528: Modul
- 2530: Output-Latency
- 2532: Modul
- 2534: Buffer-Size
- 2536: Output-Latency
- 2538: Modul
- 2540: Buffer-Size
- 2542: Output-Latency
- 2544: Modul
- 2546: Modul
- 2548: Buffer-Size

## Patentansprüche

1. Verfahren zum Programmieren von Hardware für die Verarbeitung von Nutzdaten mit folgenden Schritten:
a) eine Mehrzahl von Modulen wird zur Verfügung gestellt, wobei jedes Modul mindestens eine Funktion zum Verarbeiten der Nutzdaten ausführen kann;
b) Schnittstellen zum Verschalten der Module werden vorgegeben;
b1) wobei an einer Schnittstelle eines Moduls eine Datenstruktur existiert, die aus Nutzdatensignalen und einem Taktsignal und/oder Kontrollsignalen und/oder einem Inhibit-Signal besteht,
b1a) wobei Input-Links für den Empfang von Daten und Output-Links für die Ausgabe von Daten definiert sind, und
b1b) wobei die Schnittstellen die Verbindung eines Ausgangs eines ersten Moduls mit einem Eingang eines zweiten Moduls ermöglichen;
b2) wobei für jeden Ausgang eines Moduls eine Datenstruktur vom Typ Output-Link vorgesehen wird;
b3) wobei für jeden Eingang eines Moduls eine Datenstruktur vom Typ Input-Link vorgesehen wird; und
b4) wobei ausgangsseitig ein Modul durch eine Output-Latency charakterisiert wird, die bestimmt, welche maximale Anzahl von gültigen Datenworten ein Link noch senden kann, nachdem der Eingangsdatenfluss gestoppt wurde;
c) die Module werden nach vorgegebenen Eigenschaften in eine Mehrzahl von Modultypen klassifiziert;
c1) wobei ein O-Modul folgende Eigenschaften aufweist:
c1a) das O-Modul kann die Werte von Nutzdaten ändern, aber keine Nutzdaten löschen;
c1b) das O-Modul beeinflusst den Kontrolldatenfluss nicht;
c1c) ein Inhibit-Signal hat keinen Einfluss auf das O-Modul;
c1d) die Daten erfahren beim Durchlaufen des O-Moduls eine genau definierte Verzögerung;
c1e) bei einem O-Modul mit mehreren Input-Links müssen die Nutzdaten gleichphasig anliegen; und
c1f) bei einem O-Modul mit mehreren Input-Links wird das Inhibit-Signal identisch auf alle Input-Links geleitet;
c2) wobei ein P-Modul folgende Eigenschaften aufweist:
c2a) das P-Modul kann die Werte von Nutzdaten ändern und Nutzdaten löschen;
c2b) das P-Modul kann den Kontrolldatenfluss ändern und löschen;
c2c) ein Inhibit-Signal hat keinen Einfluss auf das P-Modul;
c2d) die Daten erfahren beim Durchlaufen des P-Moduls eine genau definierte maximale Verzögerung, wobei die Verzögerung, die einzelne Nutzdaten erfahren, auch kleiner als die maximale Verzögerung sein kann;
c2e) bei einem P-Modul mit mehreren Input-Links müssen die Daten gleichphasig anliegen,
- wobei die Funktions-Logik mit Kontrolldaten aus mindestens einem der Input-Links gespeist wird, und
- wobei das Inhibit-Signal identisch auf alle Input-Links geleitet wird; und
c3) wobei ein M-Modul folgende Eigenschaften aufweist:
c3a) das M-Modul kann die Werte von Nutzdaten ändern und Nutzdaten löschen und neue Nutzdaten erzeugen;
c3b) das M-Modul kann Kontrolldatenfluss ändern, löschen und erzeugen;
c3c) das M-Modul kann ein Inhibit-Signal erzeugen;
c3d) die Daten erfahren beim Durchlaufen des M-Moduls eine unbestimmte Verzögerung;
c3e) dass M-Module auf ihrer jeweiligen Eingangsseite einen Eingangspuffer mit einer Puffergröße zur Speicherung von Daten besitzen; und
c3f) bei einem Modul des Typs "M" mit mehreren Input-Links, können eingehende Nutzdaten sowie Kontrolldaten aus unabhängigen Quellen stammen;
d) Verschaltungsregeln werden abhängig von den Modultypen derart definiert, dass die Steuerung des Datenflusses zwischen den verschalteten Modulen über Kontroll- und Inhibit-Signale erfolgt;
d1) wobei ein sich selbst regelndes Netwerk von Datenflüssen erzeugt wird;
d2) wobei die Inhibit-Signale von einem M-Modul erzeugt werden;
d3) wobei durch ein aktives Inhibit-Signal, das Eingangssignal am Ausgang eines ersten Moduls und Ausgangssignal am Eingang eines zweiten Moduls ist, ein Datenfluss gestoppt wird, der Ausgangssignal am Ausgang des ersten Moduls und Eingangssignal am Eingang des zweiten Moduls ist;
d4) wobei sich aus einem Kontrollsignal, das Ausgangssignal am Ausgang eines ersten Moduls und Eingangssignal am Eingang eines zweiten Moduls ist, die Gültigkeit der Nutzdaten des Datenflusses, der Ausgangssignal am Ausgang des ersten Moduls und Eingangssignal am Eingang des zweiten Moduls ist, erkennen lässt;
e) wobei die Verschaltung von Modulen unterschiedlicher Modultypen nach den folgenden Regeln erfolgt:
e1) die Serienschaltung eines O- oder P-Moduls mit einem O- oder P-Modul ist uneingeschränkt möglich; und
e2) bei Verschaltung des Ausgangs eines O- oder P-Moduls mit dem Eingang eines M-Moduls muss die Buffer-Size des M-Moduls größer oder gleich sein als die Output-Latency des O- oder P-Moduls; und
e3) die Verschaltung des Ausgangs eines M-Moduls mit dem Eingang eines O-oder P-Modulen ist uneingeschränkt möglich; und
e4) bei Verschaltung des Ausgangs eines ersten M-Moduls mit dem Eingang eines zweiten M-Moduls muss die Buffer-Size des zweiten M-Moduls größer sein als die Output-Latency des ersten M-Moduls; und
e5) bei Parallelschaltung eines ersten und mindestens eines zweiten O-Moduls, deren Ausgänge mit den Eingängen eines dritten O- oder P-Moduls verschaltet werden, muss hinter oder vor dem ersten oder zweiten O-Modul, je nachdem, welches die kleinere Output-Latency hat, ein Verzögerungsregister mit so vielen Stufen eingefügt werden, wie die Differenz der Output-Latencies des ersten und zweiten O-Moduls beträgt, damit an den Eingängen des dritten Moduls eines Synchronisation der Daten gewährleistet bleibt; und
e6) eine Parallelschaltung eines ersten P- oder M-Moduls mit mindestens einem zweiten P- oder M-Modul, deren Ausgänge mit den Eingängen eines dritten O- oder P-Moduls verschaltet werden, ist unzulässig; und
e7) eine Parallelschaltung eines ersten O-, P- oder M-Moduls mit mindestens einem zweiten O-, P- oder M-Modul, deren Ausgänge mit den Eingängen eines dritten M-Moduls verschaltet werden, ist zulässig;
f) eine Verschaltung der Module, die einer für die Verarbeitung der Nutzdaten geeigneten Abfolge der Funktionen entspricht, wird vorgegeben; und
g) aus der Verschaltung der Module wird die Hardware-Programmierung erzeugt.

2. Verfahren nach dem vorhergehenden Anspruch,
**dadurch gekennzeichnet,**
**dass** zur Darstellung von Modulen für die Verarbeitung von Nutzdaten graphische Symbole verwendet werden; und
**dass** die Verschaltung der Module auf graphisch orientierter Basis nach dem Baukastenprinzip aus Modulen erstellt wird.

3. Verfahren nach einem der vorhergehenden Ansprüche,
**dadurch gekennzeichnet,**
**dass** in einem Modul mindestens eine Funktions-Logik die Verarbeitung der Nutzdaten realisiert.

4. Verfahren nach einem der vorhergehenden Ansprüche,
**dadurch gekennzeichnet,**
**dass** überprüft wird, ob die Verschaltungsregeln durch die Verschaltung der Module eingehalten sind; und
**dass** - sofern möglich - die Verschaltung der Module derart ergänzt wird, dass die Verschaltungsregeln erfüllt sind.

5. Verfahren nach einem der vorhergehenden Ansprüche,
**dadurch gekennzeichnet,**
**dass** eine Verschachtelung von Modulanordnungen erfolgt,
- wobei ein Modul aus einer Anordnung mehrerer Module aufgebaut ist, und
- wobei beliebig tiefe Strukturen möglich sind.

6. Verfahren nach einem der vorhergehenden Ansprüche,
**dadurch gekennzeichnet,**
**dass** eine Bibliothek erstellt wird;
wobei die Bibliothek eine Mehrzahl von Bausteinen umfasst;
wobei ein Baustein eine Verschachtelung und Verschaltung von Modulen zum Realisieren jeweils einer vorgegebenen Funktion realisiert.

7. Verfahren nach dem vorhergehenden Anspruch,
**dadurch gekennzeichnet,**
**dass** eine Verschaltung der Module auf graphisch orientierter Basis nach dem Baukastenprinzip aus Modulen und/oder Bausteinen aus einer Bibliothek erstellt wird.

8. Computerprogramm,
**dadurch gekennzeichnet,**
**dass** es ausführbare Instruktionen beinhaltet, welche bei Ausführung auf einer Recheneinheit, einem Mikrocontroller, DSP, FPGA oder Computer oder auf einer Mehrzahl davon in einem Netzwerk das Verfahren nach einem der vorhergehenden Verfahrensansprüche ausführt.

9. Datenträger, auf dem eine Datenstruktur gespeichert ist, die nach einem Laden in einen Arbeits- und/oder Hauptspeicher einer Recheneinheit, eines Mikrocontrollers, DSPs, FPGAs oder Computers oder einer Mehrzahl davon in einem Netzwerk das Verfahren nach einem der vorhergehenden Verfahrensansprüche ausführt.

10. Moduliertes Datensignal, welches von einer Recheneinheit, einem Mikrocontroller, DSP, FPGA oder Computer oder von einer Mehrzahl davon in einem Netzwerk ausführbare Instruktionen zum Ausführen eines Verfahrens nach einem der vorhergehenden Verfahrensansprüche enthält.

11. Logische Schaltung für die Verarbeitung von Nutzdaten erhalten durch ein Verfahren nach einem der vorhergehenden Verfahrensansprüche.

12. Graphischer Editor für die Programmierung von Hardware für die Verarbeitung von Nutzdaten:
a) mit graphischen Symbolen zur Darstellung von Modulen, wobei jedes Modul eine Funktion zum Verarbeiten der Nutzdaten ausführen kann, wenn das Modul in Hardware realisiert wird;
b) mit graphischen Symbolen zur Darstellung von unterschiedlichen Modultypen, wobei die Module nach vorgegebenen Eigenschaften gemäß Anspruch 1 in Modultypen klassifiziert werden;
c) mit mindestens einem graphischen Symbol zur Darstellung von Schnittstellen zum Verschalten der Module;
d) mit Mitteln zum Überprüfen, ob eine zulässige Verschaltung von Modulen gemäß vorgegebenen Verschaltungsregeln vorliegt, wobei die Verschaltungsregeln abhängig von den Modultypen derart definiert sind, dass die Steuerung des Datenflusses zwischen den verschalteten Modulen über Kontroll- und Inhibit-Signale erfolgt;
d1) wobei ein sich selbst regelndes Netwerk von Datenflüssen erzeugt wird;
d2) wobei die Inhibit-Signale von einem Modultyp erzeugt werden;
d3) wobei durch ein aktives Inhibit-Signal, das Eingangssignal am Ausgang eines ersten Moduls und Ausgangssignal am Eingang eines zweiten Moduls ist, ein Datenfluss gestoppt wird, der Ausgangssignal am Ausgang des ersten Moduls und Eingangssignal am Eingang des zweiten Moduls ist;
d4) wobei sich aus einem Kontrollsignal, das Ausgangssignal am Ausgang eines ersten Moduls und Eingangssignal am Eingang eines zweiten Moduls ist, die Gültigkeit der Nutzdaten des Datenflusses, der Ausgangssignal am Ausgang des ersten Moduls und Eingangssignal am Eingang des zweiten Moduls ist, erkennen lässt;
e) mit graphischen Mitteln zum Aufbau einer graphischen Darstellung einer Verschaltung von Modulen, die einer für die Verarbeitung der Nutzdaten geeigneten Abfolge der Funktionen entspricht; und
f) mit Mitteln zum Übersetzen der graphischen Darstellung der Verschaltung der Module in eine Programmierung der Hardware,
g) wobei die Verschaltungsregeln gemäß Anspruch 1 vorgegeben werden.

## Claims

1. A method for programming hardware for processing user data comprising the following steps:
a) a plurality of modules are made available, wherein each module can execute at least one function for processing the user data;
b) interfaces for interconnecting the modules are provided;
b1) wherein a data structure exists at an interface of a module which comprises user data signals and a clock signal and/or control signals and/or an inhibit signal,
b1a) wherein input links for receiving data and output links for outputting data are defined, and
b1b) wherein the interfaces enable an output of a first module to be connected to an input of a second module;
b2) wherein a data structure of the output link type is provided for each output of a module;
b3) wherein a data structure of the input link type is provided for each input of a module; and
b4) wherein a module is characterized on the output side by an output latency which determines the maximum number of valid data words a link can still send after the input data flow has been stopped;
c) the modules are classified into a plurality of module types according to predetermined properties;
c1) wherein an O module has the following properties:
c1a) the O module can change the values of user data but cannot erase user data;
c1b) the O module does not influence the control data flow;
c1c) an inhibit signal has no influence on the O module;
c1d) the data experience a precisely defined delay when passing through the O module;
c1e) in the case of an O module having a plurality of input links, the user data must be present in phase; and
c1f) in the case of an O module having a plurality of input links, the inhibit signal is passed identically to all the input links;
c2) wherein a P module has the following properties:
c2a) the P module can change the values of user data and erase user data;
c2b) the P module can change and erase the control data flow;
c2c) an inhibit signal has no influence on the P module;
c2d) the data experience a precisely defined maximum delay when passing through the P module, wherein the delay experienced by individual user data may also be less than the maximum delay;
c2e) in the case of a P module having a plurality of input links, the data must be present in phase,
- wherein the function logic is fed with control data from at least one of the input links, and
- wherein the inhibit signal is passed identically to all the input links; and
c3) wherein an M module has the following properties:
c3a) the M module can change the values of user data and erase user data and generate new user data;
c3b) the M module can change, erase and generate control data flow;
c3c) the M module can generate an inhibit signal;
c3d) the data experience an indeterminate delay when passing through the M module;
c3e) M modules have on their respective input side an input buffer having a buffer size for storing data; and
c3f) in the case of an M module having a plurality of input links, incoming user data and control data can originate from independent sources;
d) interconnection rules are defined depending on the module types such that the control of the data flow between the interconnected modules takes place by means of control and inhibit signals;
d1) wherein a self-regulating network of data flows is generated;
d2) wherein the inhibit signals are generated by an M module;
d3) wherein an active inhibit signal, which is input signal at the output of a first module and output signal at the input of a second module, stops a data flow that is output signal at the output of the first module and input signal at the input of the second module;
d4) wherein a control signal which is output signal at the output of a first module and input signal at the input of a second module allows to determine the validity of the user data of the data flow that is output signal at the output of the first module and input signal at the input of the second module;
e) wherein modules of different module types are interconnected according to the following rules:
e1) the series connection of an O or P module with an O or P module is possible without restriction; and
e2) when the output of an O or P module is interconnected with the input of an M module, the buffer size of the M module must be greater than or equal to the output latency of the O or P module; and
e3) the interconnection of the output of an M module with the input of an O or P module is possible without restriction; and
e4) when the output of a first M module is interconnected with the input of a second M module, the buffer size of the second M module must be greater than the output latency of the first M module; and
e5) in the case of parallel connection of a first and at least one second O module whose outputs are interconnected with the inputs of a third O or P module, it is necessary to insert, downstream or upstream of the first or second O module depending on which has the smaller output latency, a delay register having a number of stages equal to the difference in the output latencies of the first and second O modules, in order that synchronization of the data remains ensured at the inputs of the third module; and
e6) a parallel connection of a first P or M module with at least one second P or M module whose outputs are interconnected with the inputs of a third O or P module is not permitted; and
e7) a parallel connection of a first O, P or M module with at least one second O, P or M module whose outputs are interconnected with the inputs of a third M module is permissible;
f) an interconnection of the modules which corresponds to a sequence of functions which is valid for processing the user data is provided; and
g) the hardware programming is generated from the interconnection of the modules.

2. The method according to the preceding claim,
**characterized**
**in that** graphical symbols are used for representing modules for processing user data; and
**in that** the interconnection of the modules is created from modules on a graphically oriented basis according to a modular principle.

3. The method according to one of the preceding claims,
**characterized**
**in that** in a module at least one function logic realizes the processing of the user data.

4. The method according to one of the preceding claims,
**characterized**
**in that** a check is made to determine whether the interconnection rules are complied with by the interconnection of the modules; and
**in that** - if possible - an interconnection of the modules is supplemented in such a way that the interconnection rules are fulfilled.

5. The method according to one of the preceding claims,
**characterized**
**in that** a nesting of module arrangements is implemented,
- wherein a module is constructed from an arrangement of a plurality of modules, and
- wherein arbitrarily deep structures are possible.

6. The method according to one of the preceding claims,
**characterized**
**in that** library is created;
wherein the library comprises a plurality of components;
wherein a component realizes a nesting and interconnection of modules for realizing a respective predetermined function.

7. The method according to the preceding claim,
**characterized**
**in that** an interconnection of modules is created from modules and/or components from a library on a graphically oriented basis according to the modular principle.

8. A computer program,
**characterized**
**in that** it comprises executable instructions, which, when executed by a processing unit, a microcontroller, DSP, FPGA or computer or a plurality thereof in a network, execute the method according to one of the preceding method claims.

9. A data carrier on which is stored a data structure which executes the method according to one of the preceding method claims after being loaded into a working and/or main memory of a processing unit, of a microcontroller, digital signal processor (DSP), field programmable gate array (FPGA) or computer or a plurality thereof in a network.

10. A modulated data signal comprising instructions executable by a processing unit, a microcontroller, DSP, FPGA or computer or a plurality thereof in a network for executing the method according to one of the preceding method claims.

11. A logic circuit for processing user data obtained by a method according to one of the preceding method claims.

12. A graphical editor for programming hardware for processing user data:
a) comprising graphic symbols for representing modules, wherein each module can execute a function for processing the user data if the module is realized in hardware;
b) comprising graphical symbols for representing different module types, wherein the modules can be classified in module types according to predetermined properties according to claim 1;
c) comprising at least one graphical symbol for representing interfaces for interconnecting the modules;
d) comprising means for checking whether a permissible interconnection of modules is present in accordance with predetermined interconnection rules, wherein the interconnection rules are defined depending on the module types in such a way that the control of the data flow between the interconnected modules is effected by means of control and inhibit signals;
d1) wherein a self-regulating network of data flows is generated;
d2) wherein the inhibit signals are generated by a module type;
d3) wherein an active inhibit signal, which is input signal at the output of a first module and output signal at the input of a second module, stops a data flow that is output signal at the output of the first module and input signal at the input of the second module;
d4) wherein a control signal which is output signal at the output of a first module and input signal at the input of a second module allows to determine the validity of the user data of the data flow that is output signal at the output of the first module and input signal at the input of the second module;
e) comprising graphical means for establishing a graphical representation of an inter-connection of modules which corresponds to a sequence of functions which are valid for processing the user data; and
f) comprising means for translating the graphical representation of the interconnection of modules into a programming of the hardware,
g) wherein the interconnection rules are predetermined according to claim 1.

## Revendications

1. Procédé permettant la programmation de matériels pour le traitement de données utiles, comportant les étapes suivantes :
a) une pluralité de modules est mise à disposition, chaque module pouvant exécuter au moins une fonction destinée au traitement des données utiles ;
b) des interfaces pour le branchement des modules sont définies ;
b1) à une interface d'un module, il existe une structure de données, qui est constituée de signaux de données utiles et d'un signal d'horloge et/ou des signaux de contrôle et/ou un signal d'inhibition,
b1a) des liens d'entrée pour la réception de données et des liens de sortie pour l'édition de données étant définis, et
b1b) les interfaces permettant la liaison entre une sortie d'un premier module et une entrée d'un deuxième module ;
b2) une structure de données du type lien de sortie étant prévue pour chaque sortie d'un module ;
b3) une structure de données du type lien d'entrée étant prévue pour chaque entrée d'un module ;
b4) un module étant caractérisé du côté sortie par une latence de sortie qui détermine le nombre maximum de mots de données valides qu'un lien peut encore émettre après que le flux de données d'entrée a été arrêté ;
c) les modules sont classés selon des propriétés définies en une pluralité de types de modules ;
c1) un module O comportant les propriétés suivantes :
c1a) le module 0 peut modifier les valeurs des données utiles, mais ne peut pas effacer des données utiles ;
c1b) le module O n'influence pas le flux des données de contrôle ;
c1c) un signal d'inhibition n'a aucune influence sur le module 0 ;
c1d) les données, lorsqu'elles passent par le module 0, subissent un ralentissement exactement défini ;
c1e) avec un module O comportant plusieurs liens d'entrée, les données utiles doivent être appliquées avec la même phase ; et
c1f) avec un module O comportant plusieurs liens d'entrée, le signal d'inhibition est guidé de manière identique sur tous les liens d'entrée ;
c2) un module P comportant les propriétés suivantes :
c2a) le module P peut modifier les valeurs des données utiles et effacer des données utiles ;
c2b) le module P peut modifier et supprimer le flux des données de contrôle ;
c2c) un signal d'inhibition n'a aucune influence sur le module P ;
c2d) les données, lorsqu'elles passent par le module P, subissent un ralentissement maximal exactement défini, le ralentissement que subissent les différentes données utiles pouvant aussi être inférieur au ralentissement maximal ;
c2e) avec un module P comportant plusieurs liens d'entrée, les données utiles doivent être appliquées avec la même phase,
- la fonction logique recevant les données de contrôle à partir d'au moins un des liens d'entrée, et
- le signal d'inhibition étant guidé de manière identique sur tous les liens d'entée ; et
c3) un module M comportant les propriétés suivantes :
c3a) le module M peut modifier les valeurs des données utiles et effacer des données utiles et générer de nouvelles données utiles ;
c3b) le module M peut modifier, supprimer et générer un flux de données de contrôle ;
c3c) le module M peut générer un signal d'inhibition ;
c3d) les données, lorsqu'elles passent par le module M, subissent un ralentissement indéterminé ;
c3e) les modules M, du côté de leur entrée respective, possèdent un tampon d'entrée avec une taille de tampon adaptée au stockage des données ; et
c3f) avec un module du type « M » comportant plusieurs liens d'entrée, les données utiles entrant, ainsi que les données de contrôle peuvent provenir de sources indépendantes ;
d) des règles de branchement sont définies en fonction des types de modules, de telle sorte que la commande du flux de donnée s'effectue entre les modules branchés via des signaux de contrôle et des signaux d'inhibition ;
d1) un réseau autorégulant de flux de données étant généré ;
d2) les signaux d'inhibition étant générés par un module M ;
d3) par un signal d'inhibition actif, qui constitue un signal d'entrée à la sortie d'un premier module et qui constitue un signal de sortie à l'entrée d'un deuxième module, un flux de données est arrêté, le flux de données étant le signal de sortie à la sortie du premier module et le signal d'entrée à l'entrée du deuxième module ;
d4) à partir d'un signal de contrôle il est possible de détecter la validité des données utiles du flux de données, le signal de contrôle étant un signal de sortie à la sortie d'un premier module et un signal d'entrée à l'entrée d'un deuxième module, , le flux de données étant un signal de sortie à la sortie du premier module et un signal d'entrée à l'entrée du deuxième module ;
e) le branchement des modules de types différents étant effectué selon les règles suivantes :
e1) le branchement en série d'un module O ou P avec un module O ou P est possible sans restriction ; et
e2) lors du branchement de la sortie d'un module O ou P avec l'entrée d'un module M, la taille du tampon du module M doit être supérieure ou égale à la latence de sortie du module O ou P ; et
e3) le branchement de la sortie d'un module M avec l'entrée d'un module O ou P est possible sans restriction ; et
e4) lors du branchement de la sortie d'un premier module M avec l'entrée d'un deuxième module M, la taille du tampon du deuxième module M doit être supérieure à la latence de sortie du premier module M ; et
e5) dans le cas d'un branchement en parallèle d'un premier et d'au moins un deuxième module O, dont les sorties sont raccordées aux entrées d'un troisième module O ou P, il faut insérer en aval ou en amont du premier ou du deuxième module 0, en fonction de celui ayant la plus faible latence de sortie, un registre de ralentissement avec autant de niveaux que comporte la différence entre les latences de sortie du premier et du deuxième module O, afin qu'une synchronisation des données reste garantie aux entrées du troisième module ; et
e6) un branchement en parallèle d'un premier module P ou M avec au moins un deuxième module P ou M, dont les sorties sont raccordées aux entrées d'un troisième module O ou P, est interdit ; et
e7) un branchement en parallèle d'un premier module 0, P ou M avec au moins un deuxième module 0, P ou M, dont les sorties sont raccordées aux entrées d'un troisième module M, est autorisé ;
f) un branchement des modules, qui correspond à une suite de fonctions appropriée au traitement des données utiles, est défini ; et
g) la programmation des matériels est générée à partir du branchement des modules.

2. Procédé selon la revendication précédente,
**caractérisé en ce que**
des symboles graphiques sont utilisés pour la représentation des modules pour le traitement des données utiles ; et
**en ce que** le branchement des modules est établi sur une base orientée graphique selon le principe de modularité.

3. Procédé selon l'une quelconque des revendications précédentes,
**caractérisé en ce que**
dans un module au moins une logique de fonction réalise le traitement des données utiles.

4. Procédé selon l'une quelconque des revendications précédentes,
**caractérisé en ce**
**qu'**il est contrôlé si le branchement des modules respecte les règles de branchement ; et
en ce que - pour autant que cela soit possible - le branchement des modules est renouvelé de telle sorte que les règles de branchement sont respectées.

5. Procédé selon l'une quelconque des revendications précédentes,
**caractérisé en ce**
**qu'**il est effectué un branchement entre les agencements de modules,
- un module étant constitué d'un agencement de plusieurs modules, et
- des structures de profondeur quelconque étant possibles.

6. Procédé selon l'une quelconque des revendications précédentes,
**caractérisé en ce**
**qu'**une bibliothèque est établie ;
ladite bibliothèque comportant une pluralité de blocs fonctionnels ;
un bloc fonctionnel réalisant une imbrication et le branchement des modules pour réaliser dans chaque cas une fonction définie.

7. Procédé selon l'une quelconque des revendications précédentes,
**caractérisé en ce**
**qu'**un branchement des modules est établi sur une base orientée graphique selon le principe de modularité à partir de modules et/ou de blocs fonctionnels issus d'une bibliothèque.

8. Programme informatique
**caractérisé en ce**
**qu'**il contient des instructions exécutables qui, lors de leur déroulement sur une unité de calcul, un microcontrôleur, un DSP, un FPGA ou un ordinateur ou sur une pluralité de ceux-ci dans un réseau, exécutent le procédé selon une des revendications de procédé précédentes.

9. Support de données, sur lequel est enregistrée une structure de données qui, après un chargement dans une mémoire de travail et/ou une mémoire principale d'une unité de calcul, d'un microcontrôleur, d'un DSP, d'un FPGA ou d'un ordinateur ou dans une pluralité de ceux-ci dans un réseau, exécute le procédé selon une des revendications de procédé précédentes.

10. Signal de données modulé, lequel contient des instructions exécutables par une unité de calcul, un microcontrôleur, un DSP, un FPGA ou un ordinateur ou par une pluralité de ceux-ci dans un réseau, afin d'exécuter un procédé selon une des revendications de procédé précédentes.

11. Circuit logique pour le traitement des données utiles, obtenu par un procédé selon une des revendications de procédé précédentes.

12. Éditeur graphique pour la programmation de matériels pour le traitement de données utiles :
a) avec des symboles graphiques pour la représentation de modules, chaque module pouvant exécuter une fonction pour le traitement des données utiles lorsque le module est réalisé dans un matériel ;
b) avec des symboles graphiques pour la représentation de différents types de modules, les modules étant classifiés en type de modules selon des propriétés définies selon la revendication 1 ;
c) avec au moins un symbole graphique pour la représentation des interfaces en vue du branchement des modules ;
d) avec des moyens pour contrôler s'il existe un branchement de modules autorisé selon les règles de branchement définies, lesdites règles de branchement étant définies en fonction des types de modules, de telle sorte que la commande du flux de données s'effectue entre les modules interconnectés via des signaux de contrôle et des signaux d'inhibition ;
d1) un réseau autorégulant de flux de données étant généré ;
d2) les signaux d'inhibition étant générés par un type de module ;
d3) par un signal d'inhibition actif, le signal d'entrée est à la sortie d'un premier module et le signal de sortie est à l'entrée d'un deuxième module, un flux de données est arrêté, le signal de sortie est à la sortie du premier module et le signal d'entrée est à l'entrée du deuxième module ;
d4) à partir d'un signal de contrôle il est possible de détecter le signal de sortie à la sortie d'un premier module et le signal d'entrée à l'entrée d'un deuxième module, la validité des données utiles du flux de données, le signal de sortie à la sortie du premier module et le signal d'entrée à l'entrée du deuxième module ;
e) avec des moyens graphiques pour construire une représentation graphique d'un branchement de modules, qui correspond à une suite de fonctions appropriée au traitement des données utiles : et
f) avec des moyens pour convertir la représentation graphique du branchement des modules en une programmation des matériels ;
g) les règles de branchement étant définies selon la revendication 1.
